# FASCICULE DE BREVET EUROPEEN

(11) **EP 2 625 536 B1**
(45) Date de publication et mention de la délivrance du brevet: **13.04.2016**
(21) Numéro de dépôt: 11764791.7
(22) Date de dépôt: 07.10.2011
(51) Int. Cl.: G01R 29/10

(54) **PROCEDE ET DISPOSITIF DE TEST ELECTROMAGNETIQUE D'UN OBJET**
VERFAHREN UND VORRICHTUNG ZUM ELEKTROMAGNETISCHEN TESTEN EINES GEGENSTANDES
METHOD AND DEVICE FOR ELECTROMAGNETICALLY TESTING AN OBJECT

(30) Priorité: 08.10.2010 FR 1058193
(43) Date de publication de la demande: 14.08.2013
(73) Titulaire: MVG Industries, 91140 Villebon-sur-Yvette (FR)
(72) Inventeur: DUCHESNE, Luc, F-91470 Angervilliers (FR); LAPORTE, Raphaël, F-92270 Bois Colombes (FR)
(74) Mandataire: Regimbeau
(86) Numéro de dépôt international: PCT/EP2011/067598
(87) Numéro de publication internationale: WO 2012/045879

(56) Documents cités:
- WO-A1-2010/006891
- FR-A1- 2 797 327

## Description

L'invention concerne le test électromagnétique d'objets, comme par exemple des antennes et plus généralement le test des objets rayonnants constitués d'antennes reliées à une source et/ou un récepteur intégré, les éléments rayonnants étant considérés comme pouvant être émetteurs et/ou récepteurs de rayonnements électromagnétiques.

Dans différentes applications, on cherche à connaître la réponse des objets rayonnants à un rayonnement électromagnétique extérieur.

On peut citer, par exemple, les tests des téléphones mobiles ou des ordinateurs portables.

D'une manière générale, lorsqu'une ou plusieurs antennes sont utilisées sur un appareil, ces dernières peuvent être soumises à différents rayonnements électromagnétiques, qui peuvent être variables dans le temps et peuvent par exemple perturber la réception d'un signal utile.

Dans le cas d'un objet sous test constitué d'une ou de plusieurs antennes réceptrices, la difficulté est d'évaluer comment cet objet sous test va réagir à des rayonnements électromagnétiques pouvant être rencontrés lors de son utilisation en conditions réelles.

On cherche en particulier à générer par une ou plusieurs sondes d'émission d'un rayonnement électromagnétique pointé vers l'objet sous test un scénario électromagnétique représentatif de l'environnement de fonctionnement réel de l'objet sous test, c'est-à-dire à envoyer à chaque sonde un signal d'entrée représentatif d'un scénario électromagnétique, en fonction duquel elle émettra un rayonnement vers l'objet pour reproduire l'environnement de fonctionnement de l'objet sous test.

Un tel dispositif de test est connu par exemple par le document US-A-2008/00 56 340.

On connaît également par le document "Spatial Fading Evaluator for Handset Antennas" de H. Iwai et al., paru dans I.E.E.E. 2005, pages 218 à 221, référence 0-7803-8683-6/05, un dispositif permettant d'évaluer des signaux reçus par des antennes de combinés téléphoniques dans des environnements de propagation ou d'évanouissement multi-trajet, et ce à l'aide de diffuseurs disposés autour d'une antenne de réception.

Le document "BER Evaluation System for a Handset Antenna in a Multipth Environment using a Spatial Fading Emulator" de Tsutomu Sakata et al., dans "Proceeding of ISAP 2005, Seoul, Korea", référence ISBN : 89-86522-78-0 94460, pages 351 à 354, décrit également un dispositif de ce type.

Le document WO 2006/047677 décrit un système pour déterminer les performances de rayonnement d'un dispositif sans fil.

Ces dispositifs connus ne permettent toutefois pas de générer tous les scénarios électromagnétiques pouvant être rencontrés. De plus, ils sont compliqués à mettre en oeuvre.

L'invention vise à étendre les possibilités de génération d'un environnement électromagnétique réel, par un dispositif de test pouvant s'adapter sur tous les systèmes existants pour enrichir les simulations pouvant être obtenues.

A cet effet, l'invention concerne un procédé de test électromagnétique d'au moins un objet, procédé dans lequel on envoie par au moins une sonde un rayonnement électromagnétique suivant une direction principale déterminée de pointage vers un point test déterminé où se situe l'objet sous test.

L'invention est caractérisée en ce que l'on déplace la au moins une sonde et un support de l'objet sous test l'un par rapport à l'autre par un dispositif de déplacement mécanique suivant un mouvement représentatif d'une statistique prédéterminée d'étalement angulaire par rapport à la direction principale de pointage pour générer par la au moins une sonde un rayonnement électromagnétique ayant cette statistique prédéterminée d'étalement angulaire par rapport à la direction principale de pointage.

Grâce à l'invention, on peut faire osciller la ou les sonde(s) de façon relative autour de leur direction de pointage, pour ainsi générer un rayonnement électromagnétique dirigé vers le point test mais ayant un point d'origine variable et donc un angle d'incidence ayant un étalement angulaire en temps réel par rapport à la direction déterminée de pointage, qui est en fait une direction principale d'éclairement du point test. Le dispositif de déplacement mécanique peut ainsi faire bouger en temps réel la sonde et le support de l'objet sous test l'un par rapport à l'autre suivant une trajectoire prescrite qui est déterminée en fonction de la statistique prédéterminée d'étalement angulaire. En mesurant la réponse de l'objet sous test à cette statistique d'étalement angulaire des rayonnements électromagnétiques incidents, on peut connaître la réponse temporelle de l'objet, la statistique d'étalement angulaire du rayonnement étant également temporelle.

On pourra également utiliser en plus les autres systèmes existants permettant de faire varier temporellement des signaux électriques de commande de la ou des sonde(s), en fonction desquels la ou les sonde(s) génère(nt) des valeurs de champ électromagnétique réglables en intensité et/ou en phase.

Le mouvement représentatif d'une statistique prédéterminée d'étalement angulaire est un déplacement angulaire contrôlé de la sonde suivant une statistique définie. A chaque instant, un angle déterminé de commande et une amplitude déterminée de signaux électriques de commande sont assignés à la sonde suivant la statistique définie par un calculateur. On déplace la ou les sondes par rapport à l'objet sous test (ou l'objet sous test par rapport à la ou les sondes) d'une manière contrôlée par rapport à la direction prédéterminée de pointage de la sonde vers l'objet sous test, pour reproduire un scénario d'étalement angulaire. Le calculateur est prévu pour commander le ou les moteur(s)du dispositif de déplacement mécanique pour déplacer les sondes et/ou l'objet sous test suivant la statistique prédéterminée d'étalement angulaire.

L'invention permet donc de reproduire des scénarios électromagnétiques plus pertinents pour chaque objet sous test.

Suivant un mode de réalisation de l'invention, ledit mouvement est situé dans un plan.

Suivant un mode de réalisation de l'invention, ledit mouvement est situé dans un plan vertical pour générer la statistique prédéterminée d'étalement angulaire en élévation par le dispositif de déplacement.

Suivant un mode de réalisation de l'invention, ledit mouvement est situé dans un plan horizontal pour générer la statistique prédéterminée d'étalement angulaire en azimut par le dispositif de déplacement.

Suivant un mode de réalisation de l'invention, ledit mouvement est tridimensionnel pour générer la statistique prédéterminée d'étalement angulaire en élévation et en azimut par le dispositif de déplacement.

Suivant un mode de réalisation de l'invention, le dispositif de déplacement mécanique est prévu entre ladite au moins une sonde et une structure de support de la au moins une sonde.

Suivant un mode de réalisation de l'invention, le dispositif de déplacement mécanique comprend au moins un dispositif de déplacement angulaire de la sonde en rotation autour du point test suivant au moins un degré de liberté par rapport à la structure de support.

Suivant un mode de réalisation de l'invention, ladite au moins une sonde est l'une ou plusieurs parmi un réseau d'une pluralité de sondes supportées par une structure de support, chaque sonde ayant une direction principale de pointage distincte vers le point test.

Suivant un mode de réalisation de l'invention, l'objet sous test étant fixe sur le support, le dispositif de déplacement mécanique fait subir un mouvement déterminé de la structure de support des sondes et du support de l'objet sous test l'un par rapport à l'autre, pour faire subir à ladite au moins une sonde le mouvement représentatif de la statistique prédéterminée d'étalement angulaire par rapport à sa direction principale de pointage.

Suivant un mode de réalisation de l'invention, l'objet sous test étant fixe sur le support, le dispositif de déplacement mécanique fait subir un mouvement déterminé de la structure de support des sondes par rapport au support fixe de l'objet sous test, pour faire subir à ladite au moins une sonde le mouvement représentatif de la statistique prédéterminée d'étalement angulaire par rapport à sa direction principale de pointage.

Suivant un mode de réalisation de l'invention, l'objet sous test étant fixe sur le support, le dispositif de déplacement mécanique fait subir un mouvement déterminé du support de l'objet sous test par rapport à la structure fixe de support des sondes, pour faire subir à ladite au moins une sonde le mouvement représentatif de la statistique prédéterminée d'étalement angulaire par rapport à sa direction principale de pointage.

Suivant un mode de réalisation de l'invention, la structure de support est en forme d'arche ou d'anneau sur laquelle ou lequel les sondes sont supportées dans un plan.

Suivant un mode de réalisation de l'invention, la structure de support est de forme tridimensionnelle sur laquelle les sondes sont supportées d'une manière répartie en trois dimensions.

Suivant un mode de réalisation de l'invention, le dispositif de déplacement mécanique permet au moins un déplacement angulaire déterminé de glissement de la structure de support et du support de l'objet sous test l'un par rapport à l'autre au moins autour d'un axe géométrique non vertical.

Suivant un mode de réalisation de l'invention, le dispositif de déplacement mécanique permet un deuxième déplacement angulaire de rotation de 1a structure de support et du support de l'objet sous test l'un par rapport à l'autre au moins autour d'un axe géométrique vertical.

Suivant un mode de réalisation de l'invention, la structure de support repose sur un socle inférieur, entre le socle et la structure de support est prévu un deuxième autre système de déplacement angulaire permettant de déplacer la structure de support par rapport au socle d'un deuxième angle de même valeur absolue et opposé au déplacement angulaire de glissement du premier dispositif de déplacement mécanique du support par rapport à la structure de support, afin que le support de l'objet sous test conserve une position prescrite et sensiblement constante par rapport à la verticale, le dispositif de déplacement mécanique du support par rapport à la structure de support étant appelé premier système de déplacement relatif.

Suivant un mode de réalisation de l'invention, le deuxième autre système de déplacement angulaire comporte une pluralité de rouleaux de soutien d'une surface extérieure courbe d'une paroi de la structure de support sur le socle et au moins un moteur d'entraînement d'au moins l'un des rouleaux pour faire rouler dudit deuxième angle ladite surface extérieure courbe de la paroi de la structure de support par rapport au socle.

Suivant un mode de réalisation de l'invention, il est prévu en outre :
un organe de commande du déplacement angulaire de glissement du premier système de déplacement relatif,
au moins un capteur de mesure d'un angle réel du support de l'objet sous test par rapport à la verticale,
une boucle du moteur d'entraînement en fonction de l'angle mesuré par le capteur, pour que l'angle mesuré par le capteur soit égal à une valeur constante correspondant à ladite position prescrite du support par rapport à la verticale.

Suivant un mode de réalisation de l'invention, il est prévu une pluralité de sondes réparties de manière équiangle suivant au moins une coordonnée sphérique autour d'un même point cible des sondes.

Suivant un mode de réalisation de l'invention, il est prévu sur la au moins une sonde un système de réglage individuel de l'alignement mécanique de la sonde par rapport à un point cible, point cible où doit être centré l'objet sous test sur le support.

Suivant un mode de réalisation de l'invention, le système de réglage individuel de l'alignement mécanique de la sonde est associé à au moins une caméra optique de détection positionnée au point cible pour mesurer l'alignement mécanique de la sonde.

Suivant un mode de réalisation de l'invention, le système de réglage individuel de l'alignement mécanique de la sonde comporte une motorisation de ladite sonde sur la structure de support, pour déplacer la sonde par rapport à la structure de support suivant au moins un degré de liberté autre que suivant une direction principale de pointage de la sonde vers le point cible.

Suivant un mode de réalisation de l'invention, il est prévu un module d'analyse de l'image fournie par la caméra pour détecter dans cette image la trace de ladite sonde et un module d'asservissement de la motorisation pour aligner la trace détectée de la sonde sur une trace de consigne correspondant à l'alignement de la sonde sur le point cible.

Suivant un mode de réalisation de l'invention, la statistique prédéterminée d'étalement angulaire est une loi double exponentielle.

Suivant un mode de réalisation de l'invention, la statistique prédéterminée d'étalement angulaire est une gaussienne centrée par rapport à la direction principale de pointage et ayant un étalement angulaire défini par l'ouverture angulaire centrée autour de la direction principale de pointage, pour laquelle la moitié de l'énergie maximale du rayonnement est transportée.

Suivant un mode de réalisation de l'invention, au moins un calculateur comporte une interface permettant à un utilisateur de choisir ladite statistique d'étalement angulaire,
le calculateur calcule une pluralité de positions angulaires successives de commande du dispositif de déplacement mécanique par rapport à la direction principale prédéterminée de pointage, qui apparaissent suivant ladite statistique d'étalement angulaire ayant été choisie,
le calculateur envoie les positions angulaires successives de commande ayant été calculées à au moins un moteur du dispositif de déplacement mécanique pour faire prendre à ladite au moins une sonde des positions réelles successives déterminées correspondant aux positions de commande successives.

Suivant un mode de réalisation de l'invention, le calculateur calcule pour chaque position angulaire de commande un signal de commande de l'intensité et/ou de la phase du rayonnement électromagnétique émis par ladite au moins une sonde.

L'invention concerne également un dispositif de test électromagnétique d'au moins un objet pour la mise oeuvre du procédé de test tel que décrit ci-dessus, le dispositif comportant au moins une sonde d'émission d'un rayonnement électromagnétique suivant une direction principale déterminée de pointage vers un point test déterminé où se situe l'objet sous test, ainsi qu'un support pour l'objet sous test,
caractérisé en ce que
le dispositif de test comporte en outre un dispositif de déplacement mécanique de la au moins une sonde et du support de l'objet sous test l'un par rapport à l'autre suivant un mouvement représentatif d'une statistique prédéterminée d'étalement angulaire par rapport à la direction principale de pointage pour générer par la au moins une sonde un rayonnement électromagnétique ayant cette statistique prédéterminée d'étalement angulaire par rapport à la direction principale de pointage.

L'invention sera mieux comprise à la lecture de la description qui va suivre, donnée uniquement à titre d'exemple non limitatif en référence aux dessins sur lesquels :
- la figure 1 est une vue schématique de côté d'un mode de réalisation du dispositif de test suivant l'invention,
- la figure 2 est une vue schématique en perspective de dessus de l'intérieur du dispositif de test suivant un mode de réalisation de l'invention,
- la figure 3 est une autre vue schématique en perspective de dessus de l'intérieur du dispositif de test suivant un mode de réalisation de l'invention, montrant en plus le fond de la structure de support des sondes,
- la figure 4 est une vue schématique de face ouverte du dispositif de test suivant un mode de réalisation de l'invention,
- la figure 5 est une vue schématique en coupe transversale d'une partie du dispositif suivant un mode de réalisation de l'invention,
- les figures 6 à 9 sont des vues schématiques de face ouverte du dispositif de test suivant un mode de réalisation de l'invention dans différentes positions de glissement,
- la figure 10 est un schéma de principe d'un dispositif d'alignement d'une sonde suivant l'invention,
- les figures 11 à 16 représentent des exemples de scénarii électromagnétiques pouvant être reproduit par le dispositif suivant l'invention générant un étalement angulaire en deux ou trois dimensions,
- la figure 17 est une vue de côté du dispositif de test suivant un autre mode de réalisation de l'invention, et
- la figure 18 est un vue de dessus du dispositif de test suivant la figure 17,
- la figure 19 est un exemple numérique d'étalement angulaire en fonction du temps.

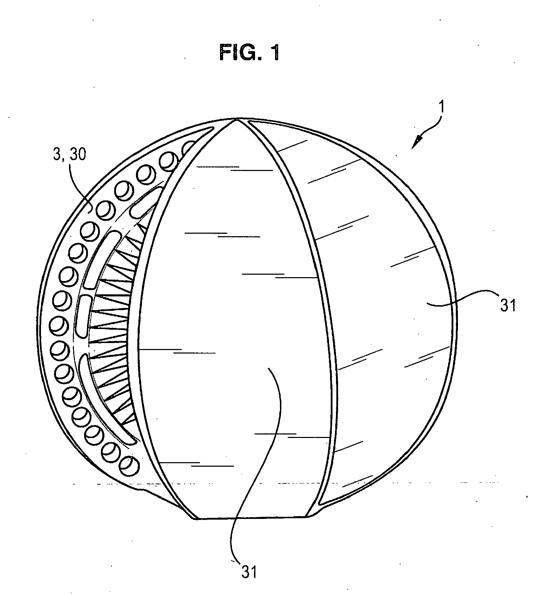

L'invention est décrite ci-dessous d'abord en référence aux figures 1 à 16 dans un mode de réalisation, dans lequel ladite au moins une sonde est l'une ou plusieurs parmi un réseau d'une pluralité de sondes 2 supportées par une structure 3 de support, chaque sonde ayant une direction principale D de pointage distincte vers le point test 40, et dans lequel le dispositif 6 de déplacement mécanique fait subir à la structure de support des sondes et au support 4 de l'objet OT sous test l'un par rapport à l'autre un mouvement relatif déterminé pour générer par ladite au moins une sonde 2 le mouvement représentatif de la statistique prédéterminée d'étalement angulaire par rapport à sa direction principale D de pointage. La direction principale D de pointage est supposée fixe pour chaque sonde 2. Chaque sonde 2 est par exemple une sonde radiofréquence.

Dans le mode de réalisation représenté aux figures 1 à 9, le dispositif 1 de test électromagnétique comporte un réseau de sondes 2 électromagnétiques fixé à une structure 3 de support. La structure 3 de support comporte à cet effet des montants 30 de support des sondes 2, ces montants 30 étant par exemple en forme d'arches s'étendant verticalement et étant par exemple conducteurs.

Le dispositif 1 comporte également un support 4 d'un ou plusieurs objets sous test, ce support 4 étant par exemple formé par un mât.

La structure 3 de support comporte au moins une paroi 31 s'étendant, suivant les trois dimensions de l'espace tout autour du support 4 de l'objet sous test pour former une cage de Faraday complètement fermée autour de l'objet sous test lorsque ce dernier se trouve sur le support 4. L'objet sous test est par exemple un objet rayonnant, ainsi qu'indiqué ci-dessus. On empêche ainsi les rayonnements électromagnétiques extérieurs de pénétrer à l'intérieur de l'espace clos délimité par la structure 3 de support. On empêche également les rayonnements électromagnétiques émis par les sondes 2 et/ou les rayonnements électromagnétiques émis par l'objet sous test disposé sur le support 4 de sortir de l'espace clos délimité par la structure 3 de support. Sur les figures 1 à 4, le dispositif de test électromagnétique est représenté avec des parties de la paroi 31 de la structure de support, qui ont été enlevées, pour montrer l'intérieur de cette dernière.

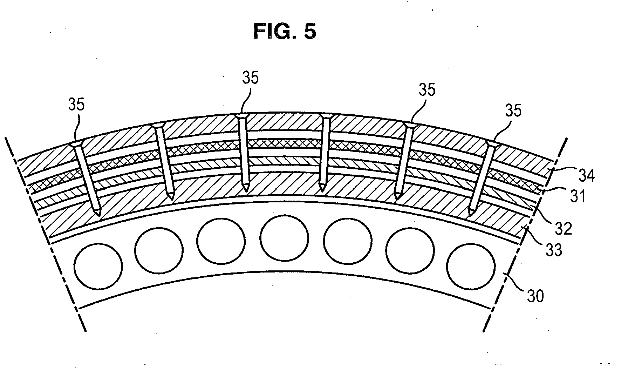

La paroi 31 ou les parois 31 est ou sont fixée(s) aux montants 30 pour empêcher toute fuite électromagnétique vers l'intérieur ou à l'extérieur, par exemple par le mode de fixation représenté à la figure 5, qui sera décrit plus en détail ci-après.

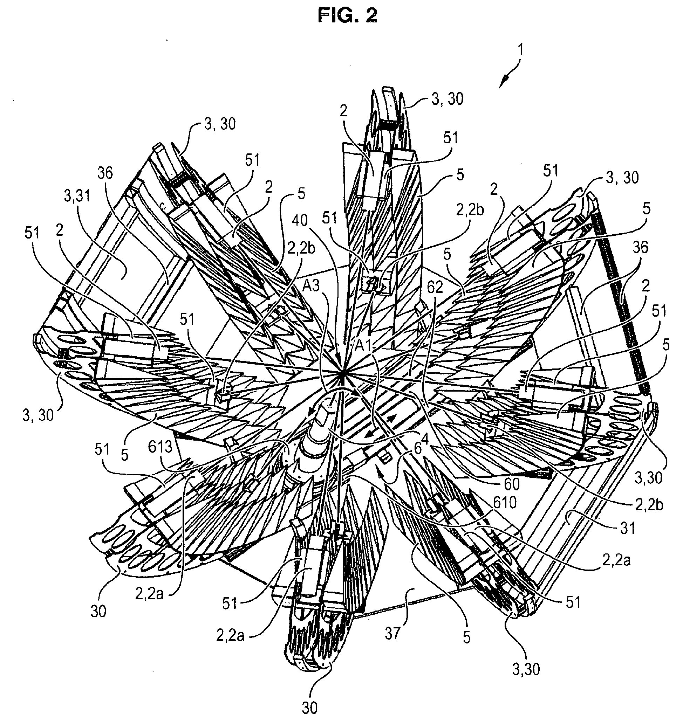

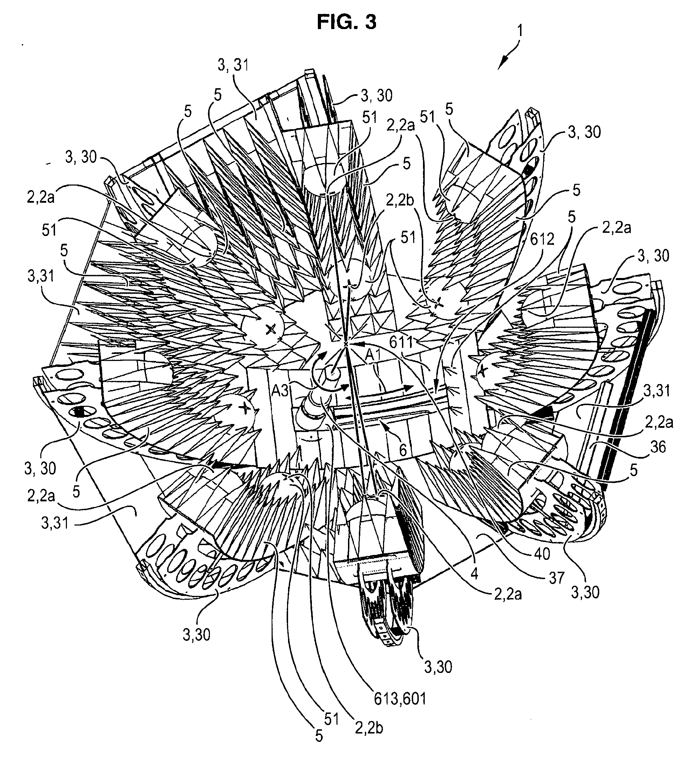

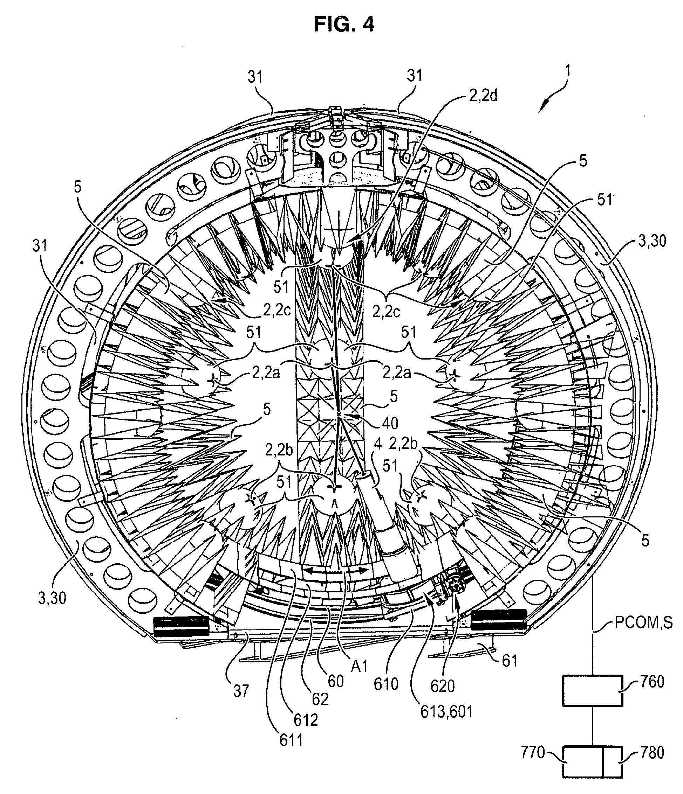

Sur son côté intérieur tourné vers l'objet sous test et le support 4, la structure 3 de support comporte des absorbeurs électromagnétiques anéchoïques 5 situés dans les intervalles entre les sondes 2. Par conséquent, les montants 30, lorsque, ainsi que représentés, ils se trouvent à l'intérieur par rapport à la paroi 31, sont recouverts d'absorbeurs électromagnétiques anéchoïques 5 tournés vers le point cible 40 des sondes 2, ce point cible 40 se trouvant en général au dessus ou à proximité du support 4 et l'objet sous test devant en général être centré en ce point test 40. La paroi 31 est recouverte, sur son côté intérieur, d'absorbeurs électromagnétiques anéchoïques 5 tournés vers le point cible 40 en lequel doit en général être centré l'objet sous test sur le support 4. Les absorbeurs électromagnétiques 5 sont par exemple pyramidaux, ainsi que représentés. Une partie d'entre eux peuvent par exemple être plats notamment pour couvrir la base 611 du système de déplacement relatif 6. Les absorbeurs 5 empêchent les rayonnements électromagnétiques émis par les sondes 2 et/ou les rayonnements électromagnétiques émis par l'objet sous test d'atteindre la ou les parois 31 et les montants 30 ou les atténuent très fortement, pour empêcher ou diminuer très fortement les réflexions pouvant être occasionnées par les montants 30 et la ou les parois 31. En effet, les montants 30 sont par exemple métalliques, notamment en acier ou aluminium. La ou les parois 31 sont conductrices et fabriquées en métal ou autre matériau conducteur pour former un mur électrique. Elles sont par exemple formées chacune d'une tôle métallique en aluminium. Les absorbeurs électromagnétiques 5 sont disposés sur toute la surface intérieure de la structure 3 à l'exception des sondes 2, lesquelles sont enrobées d'absorbeurs électromagnétiques spécifiques 51 par exemple de forme plane comme sur la figure 2 ou bien conformés comme sur les figures 3 et 4, les absorbeurs 5 se trouvant donc autour et entre les sondes 2 munies de leurs absorbeurs spécifiques 51.

Les parois 31 sont, par exemple, courbes en étant orientées vers le support 4. Il est par exemple prévu une pluralité de parois 31 avec chacune des parois 31 fixées entre deux montants 30 successifs. Les montants 30 sont, par exemple, aux figures 1 à 4, en forme d'arches semi-circulaires s'étendant le long d'un méridien d'une sphère, pour donner à la structure 3 de support une forme générale sphérique. La ou les parois 31 formant cage de Faraday peuvent n'être courbes, ainsi que représenté, que dans le sens vertical, c'est-à-dire être formées chacune d'une portion d'un cylindre ayant son axe géométrique horizontal. La ou les parois 31 formant cage de Faraday peuvent également être de forme générale sphérique. Ou encore la ou les parois 31 formant cage de Faraday peuvent également être facettées. En outre, dans l'une des parois 31 est prévue une porte permettant à une personne de pénétrer à l'intérieur de la structure 3 pour y introduire et/ou enlever l'objet sous test sur le support 4.

Dans le mode de réalisation de la figure 5, une paroi 31 est fixée sur le côté extérieur d'un montant 30. Un joint radiofréquence 32 (aussi appelé joint RF) est prévu entre le montant 30 et la paroi 31 pour assurer une étanchéité vis-à-vis des rayonnements électromagnétiques entre l'intérieur et l'extérieur. De tels joints RF 32 sont, par exemple, formés d'un ruban métallique, constitué par exemple de fils métalliques tricotés. Un tel joint 32 permet de s'adapter aux formes courbes ou facettées.

En outre, un premier arceau métallique conducteur 33 est fixé au côté extérieur du montant 30, le joint RF 32 se trouvant entre le premier arceau 33 et la paroi 31. Un deuxième arceau métallique conducteur 34 est prévu sur le côté extérieur de la paroi 31 en face du joint RF 32, la paroi 31 se trouvant donc entre le deuxième arceau 34 et le joint RF 32. Le premier arceau 33, le joint RF 32, la paroi 31 et le deuxième arceau 34 sont fixés les uns aux autres par des vis 35 les traversant depuis l'extérieur. Bien entendu, tout autre moyen 35 de fixation pourrait être prévu. Ces moyens 35 de fixation permettent, en rapprochant le deuxième arceau 34 du premier arceau 33, de comprimer le joint RF 32 pour assurer la continuité du blindage électromagnétique, ainsi que de fixer la paroi 31 au montant 30.

Comme montré sur les figures 2 et 3, des traverses 36 peuvent également être prévues entre les montants 30 et derrière les absorbeurs 5 entre ceux-ci et la paroi 31, pour rigidifier la structure de support. De plus, à l'aide de ces traverses 36, le principe d'étanchéité électromagnétique décrit dans l'exemple de la figure 5 peut être réemployé pour raccorder les parois 31 d'un point de vue blindage électromagnétique dans le cas où les parois 31 sont composées de plusieurs morceaux dans le sens du méridien.

La géométrie circulaire des montants 30 dans le mode de réalisation représenté aux figures 1 à 5 permet de disposer de manière régulière les sondes 2 autour du support 4 et autour de son point cible 40 en géométrie sphérique. Par exemple, l'écartement angulaire azimutal entre les montants 30 en forme d'arches circulaires est le même pour tous les montants 30. De même l'écartement angulaire entre les sondes 2, situées sur un même montant 30, par rapport à l'axe horizontal passant par le point cible 40 et perpendiculaire au plan du montant 30 est par exemple le même pour toutes les sondes 2. Ainsi, si l'on considère que les montants 30 représentent les méridiens d'une sphère, il est par exemple prévu un premier jeu de n sondes 2, appelées 2a, situées sur un même plan équatorial passant par le point cible 40, un deuxième jeu de n sondes 2, référencées 2b, situé dans un deuxième plan parallèle au premier plan équatorial et disposé à un deuxième angle de latitude négatif par rapport au premier jeu de sondes 2a, un troisième jeu de n sondes 2, appelées 2c, situé sur un troisième plan parallèle au premier plan équatorial et écarté d'un troisième angle de latitude par rapport à ce plan équatorial, ce troisième angle ayant la même valeur absolue que le deuxième angle mais étant en sens opposé, ainsi qu'une autre sonde 2, 2d, située au sommet de la sphère, c'est-à-dire au point d'intersection supérieur des montants 30, formant le pôle nord de la sphère. Les sondes 2 sont écartées de manière équiangle dans chacun des premiers, deuxièmes et troisièmes plans indiqués ci-dessus. Le deuxième angle et le troisième angle sont par exemple égaux à 45° en valeur absolue, de même que les angles de longitude entre les méridiens formés par les montants 30. Dans le mode de réalisation représenté à la figure 2, cet angle d'écartement est par exemple identique en longitude et en latitude, en étant par exemple égal à 45°. Dans ce cas particulier de mode de réalisation, les sondes sont réparties sur m méridiens et p = m/2 - 1 plans de latitude, avec une sonde éventuellement présente au sommet de la structure 3.

Dans le mode de réalisation représenté aux figures 2 à 4, le support 4 se trouve à l'intérieur du volume clos défini par la structure 3 de support.

Dans le mode de réalisation représenté aux figures 1 à 9, le système 6 de déplacement relatif de la structure 3 de support des sondes 2 et du support 4 de l'objet sous test l'un par rapport à l'autre est prévu à l'intérieur du volume clos défini par cette structure 3 de support et les parois 31. Ce système 6 de déplacement permet de déplacer la structure 3 de support et le support 4 relativement l'un par rapport à l'autre suivant au moins un degré de liberté, et par exemple selon au moins deux degrés de liberté, comme par exemple suivant au moins un déplacement angulaire autour d'un axe géométrique passant par le point cible 40, pouvant comprendre par exemple un déplacement angulaire A1 dans un premier plan non horizontal et par exemple vertical, passant par le point cible 40 et/ou un autre déplacement angulaire dans un autre plan non horizontal et par exemple vertical, passant par le point cible 40 et sécant du premier plan et/ou un autre déplacement angulaire autour de l'axe géométrique vertical passant par le point cible 40. Dans le mode de réalisation représenté aux figures 2 à 4, le système 6 comporte des moyens pour effectuer un premier déplacement angulaire relatif de la structure 3 de support des sondes et du support 4 l'un par rapport à l'autre suivant un premier angle A1 de glissement dans un plan non horizontal et par exemple vertical (déplacement de glissement) et effectuer l'autre déplacement angulaire A3 relatif de rotation suivant un autre angle de rotation autour de l'axe géométrique vertical passant par le point cible 40, ce qui permet d'avoir toutes les dispositions relatives possibles des sondes 2 par rapport au support 4 et au point cible 40, et permet ainsi de réaliser un suréchantillonnage spatial au moyen du réseau de sondes 2 lors d'une mesure du champ électromagnétique. Ce système 6 de déplacement relatif est, par exemple, selon le document WO 2010/006891.

Ce système 6 comporte un premier système 60 de déplacement angulaire relatif de la structure 3 de support et du support 4 l'un par rapport à l'autre suivant le premier angle A1 de glissement. Ce premier système 60 de déplacement angulaire comporte par exemple un rail 62 de guidage en arc de cercle fixé à une partie inférieure et intérieure de la structure 3 de support, le rail 62 et la palette 610 supportée par ce rail 62 se trouvant donc à l'intérieur du volume clos défini par la structure 3 de support, les parois 31 et la partie inférieure. La palette 610 peut être déplacée angulairement suivant le premier angle A1 de glissement sur le rail 62, des moyens 620 étant prévus pour déplacer la palette 610 sur le rail 62. Un autre système 601 de déplacement relatif du support 4 de l'objet sous test et de la structure 3 de support en rotation l'un par rapport à l'autre autour d'un axe vertical est prévu, par exemple par le fait que le support 4 est monté sur la palette 610 par l'intermédiaire de moyens 613 de rotation qui permettent au support 4 de tourner par rapport à la palette 610 angulairement suivant l'angle A3 de rotation. Ces moyens 613 de rotation permettent ainsi à la structure 3 et au support 4 de tourner l'un par rapport à l'autre. Les figures 3 et 4 montrent la plaque 611 de couverture du système 6, laquelle est également recouverte d'absorbeurs 5 et comporte un passage 612 pour le déplacement du support 4 dans celui-ci, une paroi inférieure conductrice 37 formant cage de Faraday étant prévue sous le système 6 de déplacement. Le système 6 de déplacement relatif de la structure 3 de support et du support 4 de l'objet sous test l'un par rapport à l'autre se trouve donc totalement inclus à l'intérieur de la « Faradisation intégrée » du système de mesure, ce qui évite par exemple toute ouverture dans la paroi inférieure 37 et donc toute rupture de la Faradisation pour faire passer le support 4. Le système 6 est recouvert d'absorbeurs électromagnétiques 5, 51 au moyen de la plaque de couverture 611 et permet donc la continuité de l' « anéchoisation intégrée » du système de mesure ce qui évite par exemple toute rupture de la couverture d'absorbants et donc toute réflexion et/ou diffraction parasite.

Le dispositif de déplacement mécanique de la au moins une sonde et de l'objet sous test l'un par rapport à l'autre pour faire subir à la au moins une sonde un mouvement relatif représentatif d'une statistique prédéterminée d'étalement angulaire par rapport à la direction principale D de pointage pour générer par la au moins une sonde un rayonnement électromagnétique ayant cette statistique prédéterminée d'étalement angulaire par rapport à la direction de pointage, est par exemple formé par le système 6 de déplacement, pour faire subir à la sonde le premier angle A1 de glissement relatif dans un plan vertical et le deuxième angle A3 de rotation relative autour d'un axe vertical. La statistique prédéterminée d'étalement angulaire peut être un angle en une dimension (angle dans un plan) ou deux dimensions (angle solide). Le point test est représenté par le point cible 40 où doit se trouver l'objet sous test et qui représente une direction de visée de chaque sonde 2 vers le point test 40. Un calculateur est prévu pour envoyer, par une interface appropriée de sortie de signaux électriques de commande, des commandes de déplacement angulaire suivant le premier et/ou deuxième angle à un actionneur du dispositif de déplacement mécanique, ces commandes correspondant en temps réel à la statistique prédéterminée d'étalement angulaire, pouvant être choisie à l'avance sur le calculateur par une interface appropriée. Par conséquent, le système 6 déplace le support 3 des sondes 2 et l'objet sous test placé au point cible 40 l'un par rapport à l'autre d'un premier et/ou deuxième angle correspondant à la statistique prédéterminée d'étalement angulaire.

Bien entendu, seul le premier système 60 de déplacement angulaire relatif de la structure de support pourrait former ce dispositif de déplacement mécanique pour faire subir à la sonde uniquement le premier angle de glissement relatif dans un plan vertical ou seul le deuxième système 601 de déplacement du support 4 de l'objet sous test et de la structure 3 de support en rotation l'un par rapport à l'autre autour de l'axe vertical est prévu, pour faire subir à la sonde uniquement le deuxième angle de rotation relative autour de l'axe vertical.

Par exemple, dans un mode de réalisation, la structure 3 de support est fixe et c'est le support 4 qui est déplacé par le système 6, 60, 601 de déplacement relatif par rapport à la structure 3 de support.

Par exemple, dans un autre mode de réalisation, le support 4 est fixe et c'est la structure 3 de support qui est déplacée par le système 6, 60, 601 de déplacement relatif par rapport au support 4.

Par exemple, dans un autre mode de réalisation, par rapport à un point fixe de référence, la structure 3 de support est déplacée suivant l'un des angles A1 et A3 par le système 6, 60, 601 de déplacement relatif et par rapport à ce même point fixe de référence le support 4 est déplacé par le système 6, 60, 601 de déplacement relatif suivant l'autre des angles A1 et A3.

Bien entendu, il pourrait être prévu une seule sonde 2 sur une structure 3 de support autre que celle décrite ci-dessus.

Par ailleurs, dans ce qui précède, la structure 3 de support peut être autre que celle décrite ci-dessus.

Dans un mode de réalisation de l'invention, il est prévu, entre un socle inférieur 61 destiné à être posé sur le sol et la structure 3 de support, à l'intérieur de laquelle est fixé le premier système 6 de déplacement relatif de la structure 3 de support par rapport au support 4 de l'objet sous test, un autre deuxième système 63 de déplacement relatif de la structure 3 de support par rapport au socle 61. Ce deuxième système 63 de déplacement angulaire est analogue au premier système 60 de déplacement angulaire pour pouvoir déplacer dans le même premier plan vertical angulairement la structure 3 de support par rapport au socle 61, mais du deuxième angle A2 de glissement opposé au premier angle A1 de glissement (le deuxième angle A2 a même valeur absolue d'angle que le premier angle A1 mais est de sens opposé au premier angle A1), afin que le support 4 reste substantiellement dans une position prescrite verticale, pour compenser en temps réel le basculement du support 4 et s'affranchir des effets de la gravité sur ce support 4. Le deuxième angle A2 de glissement et le premier angle A1 de glissement sont autour du même axe X géométrique, qui est un axe passant par le point cible 40 et par exemple horizontal.

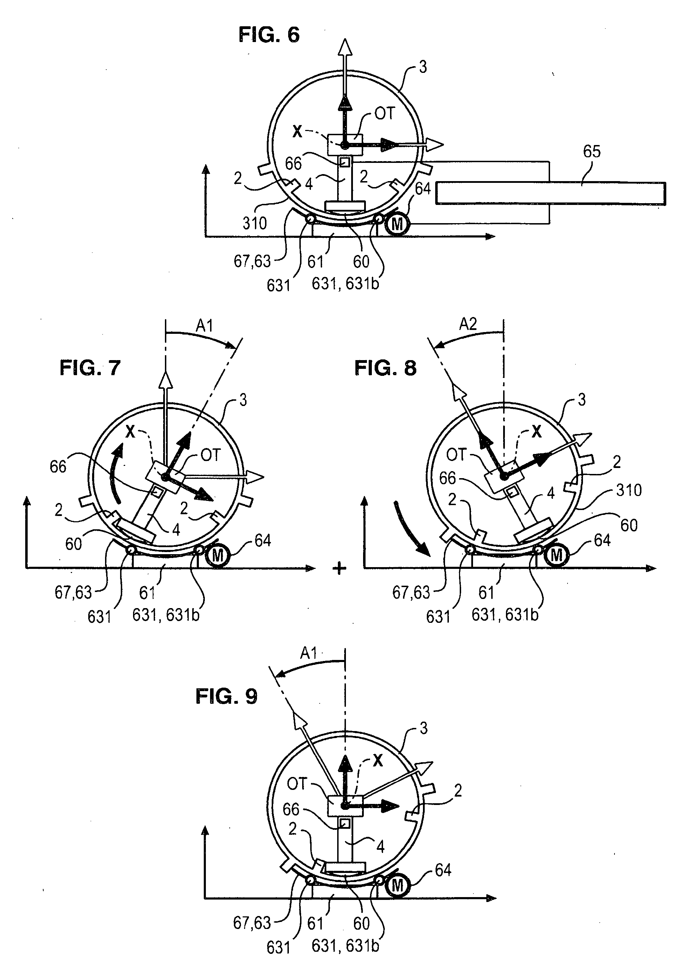

On a représenté aux figures 6 à 9 dans le premier plan vertical un exemple de réalisation du deuxième système 63 de déplacement relatif de la structure 3 de support par rapport au socle 61. Ce système 63 comporte plusieurs rouleaux 631 de soutien, de guidage et de roulement pour la surface extérieure 310 des parois 31 de la structure 3 de support, cette surface extérieure 310 étant courbe et par exemple sphérique. L'un ou plusieurs 631b des rouleaux 631 est entraîné en rotation par un moteur 64 pour faire rouler du deuxième angle A2 la surface extérieure 310 par rapport au socle 61. Les rouleaux 631 sont portés par un châssis 67 permettant le passage de la surface extérieure 310 entre les rouleaux 631, ce châssis 67 ayant par exemple une surface courbe et concave vers la surface 310, ce châssis 67 étant par exemple un berceau ou étant appelé luge de roulis et étant formé par une portion de sphère. Bien entendu, il peut être prévu plusieurs rouleaux 631 dirigés parallèlement à l'axe autour duquel se font les déplacements angulaires A1 et A2, mais également plusieurs autres rouleaux parallèles à une ou plusieurs autres directions, pour limiter la course de la surface 310 sur le châssis 67.

Un exemple de fonctionnement des systèmes 6 et 63 est décrit ci-dessous de manière décomposée et de façon fictive en référence aux figures 7 et 8, pour passer de la position de la figure 6 à la position de la figure 9.

L'utilisateur commande par un organe de commande le déplacement angulaire du premier système 60 pour déplacer la structure 3 de support des sondes 2 et le support 4 de l'objet sous test OT relativement l'un par rapport à l'autre du premier angle A1 déterminé de glissement autour du premier axe géométrique X à la figure 7. On a représenté à la figure 7 le mouvement goniométrique A1 du support 4 par rapport à la structure 3, les angles A1 et A2 étant initialement supposés nuls à la figure 6.

Sur le support 4 de l'objet sous test OT est prévu un capteur 66 de mesure de l'angle réel d'inclinaison du support 4 par rapport à la verticale. Dans la position représentée à la figure 6, ce capteur 66 mesure donc un angle réel d'inclinaison nulle par rapport à la verticale. Dans la position fictive représentée à la figure 7, ce capteur 66 mesure donc un angle réel d'inclinaison A1 par rapport à la verticale.

Le moteur 64 et le capteur 66 sont reliés à une boucle 65 d'asservissement pour commander le moteur 64 d'entraînement en fonction de l'angle réel d'inclinaison du support 4 par rapport à la verticale, mesuré de manière instantanée par le capteur 66.

La boucle 65 possède un correcteur ayant en grandeur de consigne un angle mesuré nul du capteur 66 correspondant à la position prescrite du support 4. Le correcteur agit sur la commande du moteur 64 pour corriger l'angle réel mesuré par le capteur 66 et le rendre égal à cette grandeur de consigne.

Dans la position fictive de la figure 8, cette boucle 65 d'asservissement fait tourner, par l'intermédiaire du rouleau 631b mené par le moteur 64, la surface 310 et la structure 3 de support des sondes 2 d'un angle A2 égal à l'opposé à l'angle réel A1 d'inclinaison mesuré par le capteur 66, autour de l'axe géométrique X par rapport au socle 61 fixe et au châssis 67 fixe. On a représenté à la figure 8 la rotation inverse A2 de la surface 310 de la structure 3 de support des sondes 2 par rapport au socle 61.

A la figure 9, la combinaison du mouvement goniométrique A1 de la figure 7 et de la rotation inverse A2 de la figure 8 ramène le support 4 de l'objet OT dans la position prescrite de la figure 6 par rapport à la verticale, position prescrite dite à la verticale, dans laquelle le mât 4 est considéré comme étant positionné à la verticale.

Le mouvement goniométrique A1 de la figure 7 et la rotation inverse A2 de la figure 8 sont simultanés et synchronisés parla boucle 65 d'asservissement en position. La verticalité du mât 4 est ainsi assurée en permanence. Ainsi dès que le premier système 60 veut déplacer angulairement le support 4 autour de l'axe X, la boucle 65 provoque le déplacement angulaire de la structure 3 de support des sondes 2 en sens inverse pour maintenir vertical le support 4. Les figures 7 et 8 sont fictives en ce que le mouvement goniométrique et la rotation inverse sont réalisées par petits pas successifs qui n'inclinent pas le support 4 autant qu'il est représenté. Au final, c'est à la figure 9 seulement qu'est représentée la structure 3 de support des sondes 2 qui a tourné relativement du premier angle A1 par rapport au support 4, ce dernier en restant dans la même position à la verticale pendant tout le mouvement.

En effet, le basculement du support 4 par rapport à la verticale provoquerait une flexion de celui-ci sur sa hauteur séparant le point cible 40, où doit être disposé l'objet sous test, et la structure 3 de support, ce qui fausserait le positionnement du point cible 40. En effet, une très grande précision est requise sur le positionnement du point cible 40 par rapport au point d'intersection théorique de visée des sondes 2. Le point cible 40 où est disposé l'objet sous test doit se trouver en ce point d'intersection théorique de visée des sondes 2 ou être très proche de ce point d'intersection théorique de visée des sondes 2. Par exemple, pour une fréquence de 6 GHz de fonctionnement des sondes, le point cible 40 doit se trouver dans un cube théorique de 1,5 mm de côté autour de ce point d'intersection théorique de visée des sondes 2. Pour des sondes fonctionnant à 18 GHz, le point cible 40 doit se trouver dans un cube théorique de 500 µm de côté autour de ce point d'intersection théorique de visée des sondes 2. Par conséquent, la flexion du support 4 qui est provoquée par son inclinaison par rapport à la verticale risque de faire sortir le point cible de ces tolérances de positionnement. Grâce aux deux systèmes de positionnement angulaire complémentaires mentionnés ci-dessus, à savoir le premier système 60 de positionnement angulaire du support 4 situé à l'intérieur de la structure 3 de support et le deuxième système 63 de positionnement angulaire disposé entre la structure 3 de support et le socle 61 fixe au sol, on maintient dans une position verticale prescrite le support 4 et c'est la structure 3 de support qui bouge angulairement de façon relative par rapport au socle 61 et au support 4 de l'objet sous test. Ce double système est dit antigravitationnel. Ce double système permet de disposer sur le support 4 des objets plus lourds, qui ne risquent donc pas de faire fléchir le support 4, voire d'endommager le support 4, voire de tomber du fait d'une trop forte inclinaison et ainsi de compromettre la précision des mesures, voire la faisabilité des mesures tout simplement. De plus, ce système antigravitationnel permet par exemple d'avoir des espacements angulaires entre sondes 2 plus important et donc de réduire le nombre de sondes 2 car le débattement du mouvement goniométrique du système 6 ne se trouve plus limité en amplitude par les contraintes de flexion et de torsion du support 4. Ce système dit antigravitationnel permet ainsi de réaliser des étalements angulaires sur des ouvertures angulaires accrues en s'affranchissant des contraintes mécaniques en flexion exercées par l'objet sous test lors du basculement du support 4.

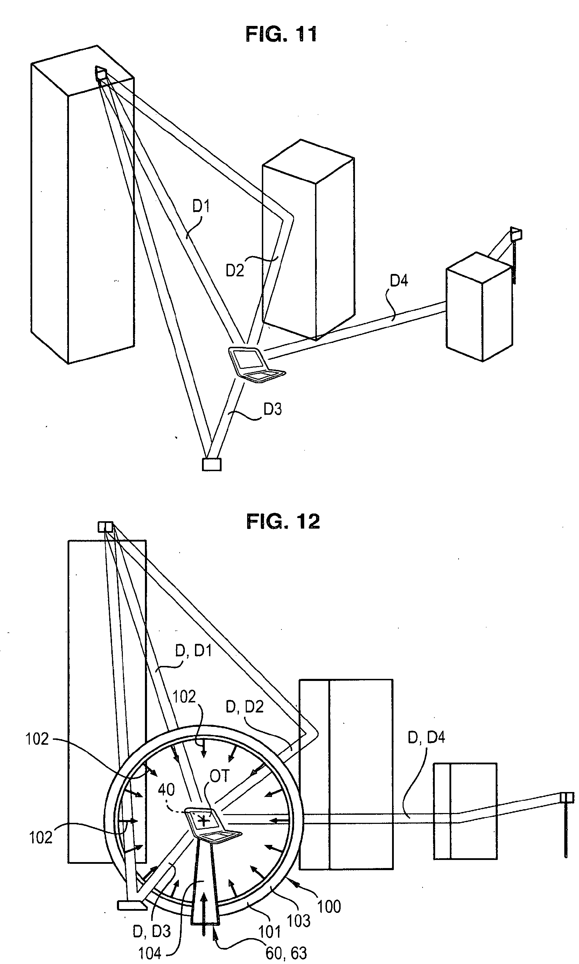

On a représenté aux figures 11 à 16 des exemples d'étalement angulaire.

A la figure 11, dans un canal de propagation, le signal arrive de plusieurs directions: la direction principale D1 correspondant à la direction 'station de base-mobile', ainsi que des directions secondaires D2, D3 crées par la réflexion du signal principal sur des bâtiments et des obstacles. I1 peut aussi exister des signaux d'interférences D4 provenant d'autres sources de rayonnement non souhaitées. Toutes ces directions D1, D2, D3, D4 constituent ce qu'on appelle les directions d'arrivée, qui sont matérialisées par les 'spots' à la figure 11 qui représente un scénario de propagation donné.

La figure 12 est une reproduction des directions d'arrivée de la figure 11 dans le plan des élévations. Si on prend une coupe verticale du scénario représenté à la figure 11; l'antenne OT de réception voit arriver les trajets directs et indirects D1, D2, D3 et D4 projetés dans le plan vertical suivant 4 angles d'élévation différents. Cette coupe du scénario de propagation peut être reproduite à l'aide d'un dispositif de test électromagnétique formé par une arche 101 de mesure verticale, dans laquelle les sondes 102 sont réparties dans un plan vertical, sur une structure 103 de support en forme d'arche ou d'anneau, un support 104 pour l'objet OT sous test étant prévu. Le premier système 60 de déplacement angulaire suivant le premier angle A1 de glissement dans le plan de l'arche autour du point cible 40 où se trouve l'objet OT sous test sur le support 4 est prévu pour déplacer la structure 103 de support des sondes 102 et le support 104 de l'objet sous test l'un par rapport à l'autre, le deuxième système 63 de déplacement angulaire et les éléments similaires à ceux décrits précédemment étant par exemple prévus avec un fonctionnement similaire.

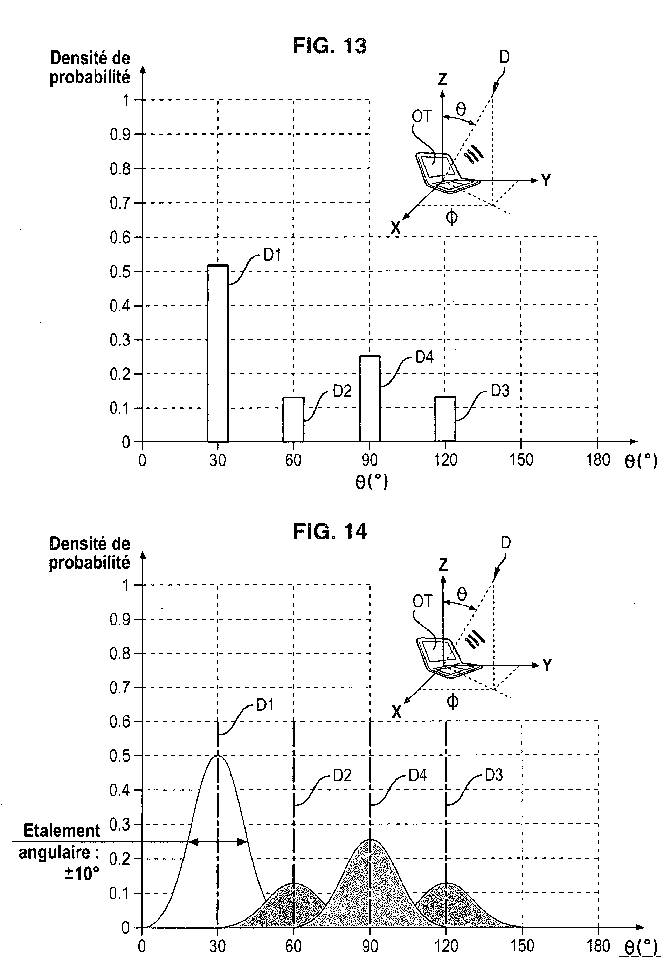

En supposant à la figure 13 que la structure 103 de support et le support 104 sont fixes, l'objet sous test voit arriver l'énergie portée par chaque trajet de directions différentes D1, D2, D3 et D4 suivant les angles d'élévation, désignées d'une manière générale par la référence D. Sur la figure 13, ces directions d'arrivée D1, D2, D3 et D4 sont matérialisées par des barres dont la hauteur est proportionnelle à l'énergie qu'elles transportent, en fonction de leur angle θ d'élévation. Cette figure 13 correspond à la densité de probabilité de la puissance reçue par l'objet sous test en fonction de l'angle d'élévation.

Seulement, dans l'environnement réel, d'autres directions d'arrivée coexistent à proximité de ces directions principales D1, D2, D3 et D4. De ce fait, dans l'environnement réel, le mobile ne voit pas arriver le signal que de la direction principale, mais aussi d'autres directions étalées autour de cette dernière. Cet étalement est décrit grâce à une loi de densité de probabilité, c'est-à-dire la probabilité que l'énergie arrive d'une direction de l'espace donnée. L'étalement suit une loi mathématique bien définie dont les paramètres sont l'angle D d'arrivée principale et l'étalement angulaire, l'étalement angulaire correspondant par définition à l'ouverture angulaire à laquelle on reçoit la moitié de l'énergie transportée par la direction d'arrivée principale.

On déplace la structure 103 de support des sondes 102 et le support 104 de l'objet OT sous test l'un par rapport à l'autre en actionnant le premier système 60 de déplacement angulaire (mouvement goniométrique) suivant le premier angle A1 de glissement suivant les angles θ d'élévation, par exemple pour que l'énergie incidente autour de chaque direction D vue par l'objet OT sous test sur le support 104 suive une répartition Gaussienne par exemple en fonction de l'angle θ d'élévation. La figure 14 est à titre d'exemple une représentation de l'énergie incidente vue par l'objet OT sous test en élévation autour de chaque direction D suivant cette répartition Gaussienne lorsque l'on actionne le goniomètre 60 qui génère un battement de ±10° autour de la position centrale de chaque direction principale D1, D2, D3 et D4 d'arrivée. On remarque qu'on a généré un étalement de l'énergie incidente autour des directions D1, D2, D3 et D4 d'arrivée en élévation. D'une manière générale, la valeur du débattement angulaire peut être choisie non nulle et inférieure à l'espacement entre deux sondes consécutives pour réaliser l'ouverture angulaire souhaitée.

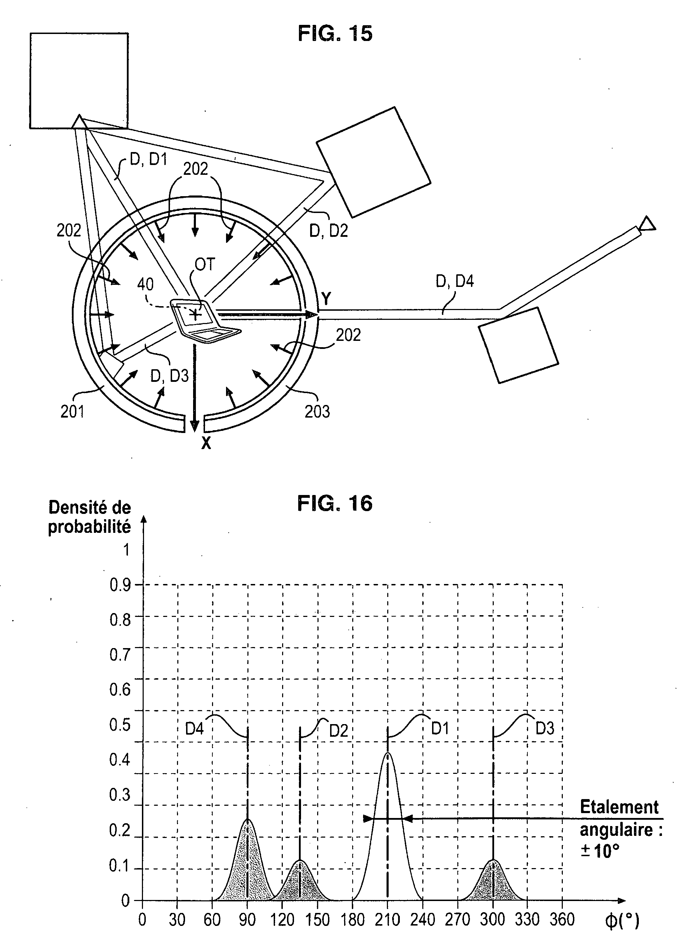

On décrit ci-dessous la reproduction des directions d'arrivée en azimut à la figure 15.

La figure 15 est une coupe horizontale du scénario représenté à la figure 11; l'antenne OT de réception voit arriver les projections sur le plan horizontal des trajets directs et indirects D1, D2, D3 et D4 suivant 4 angles d'azimuts différents.

Cette coupe du scénario de propagation peut être reproduite à l'aide d'un dispositif de test électromagnétique formé par une arche 201 de mesure horizontale, dans laquelle les sondes 202 sont réparties dans un plan horizontal sur une structure 203 de support en forme d'arche ou d'anneau, un support 4 pour l'objet OT sous test étant prévu. L'autre système 601 de déplacement du support 4 de l'objet sous test et de la structure 3 de support en rotation l'un par rapport à l'autre autour d'un axe vertical suivant un angle d'azimut dans le plan de l'arche autour du point cible 40 où se trouve l'objet OT sous test sur le support 4 est prévu. Par exemple, c'est le support 4 qui tourne autour de l'axe vertical grâce aux moyens décrits précédemment.

Par exemple, l'ouverture angulaire est non nulle et inférieure ou égale à 20°.

On déplace la structure 203 de support des sondes 202 et le support 4 de l'objet OT sous test l'un par rapport à l'autre en actionnant le système 601 de déplacement en rotation suivant l'angle Φ d'azimut, par exemple pour que l'énergie incidente autour de chaque direction principale D vue par l'objet OT sous test sur le support 104 suive une répartition Gaussienne par exemple en fonction de l'angle Φ d'azimut. La figure 16 est à titre d'exemple une représentation de l'énergie incidente vue par l'objet OT sous test en azimut autour de chaque direction principale D suivant cette répartition Gaussienne lorsque l'on actionne le dispositif 601 rotatif qui génère un battement de ±10° autour de la position centrale de chaque direction principale D1, D2, D3 et D4 d'arrivée. On remarque qu'on a généré un étalement de l'énergie incidente cette fois-ci autour des directions d'arrivée en azimut.

En utilisant le dispositif 1 de test électromagnétique décrit ci-dessus, par exemple en forme de sphère de mesure en 3D, en peut reproduire une combinaison d'étalement angulaire en élévation et en azimut suivant les figures 14 et 16, en combinant le mouvement de basculement (glissement) du goniomètre 60 et de rotation 601 du support 4. On obtient alors une reproduction d'un étalement angulaire en trois dimensions permettant de représenter dans les 3 dimensions de l'espace le canal de propagation.

Les étalements angulaires en 2 dimensions ne traduisent qu'une projection des directions principales et étalées (donc approche limitée), alors que l'étalement angulaire en 3 dimensions représente le canal de propagation réel en 3 dimensions.

Les étalements angulaires sont physiquement réalisés au moyen du goniomètre (2D vertical, 2D signifiant deux dimensions), de l'axe de roulis en azimut (2D horizontal) et de la combinaison des deux (3D, 3D signifiant trois dimensions). La méthode duale consiste à utiliser les mouvements d'orientation des sondes en laissant fixe l'antenne sous test.

A ces mouvements mécaniques, on peut aussi associer des variations de l'amplitude et/ou de la phase de la sonde de mesure pour réaliser et affiner la loi de probabilité souhaitée (Gaussienne, double exponentielle, etc). Par exemple, on utilise les mouvements mécaniques du goniomètre et/ou de l'axe d'azimut associés à une variation de l'amplitude des sondes illuminatrices pour créer une loi de probabilité d'étalement angulaire au niveau de l'objet sous test.

Par exemple, les écarts angulaires choisis autour d'une valeur fixe sont de + ou - 10 degrés (soit une amplitude de mouvement mécanique de 20 degrés en tout).

Il y a plusieurs façons de réaliser l'étalement angulaire :
- Par mouvements mécaniques du goniomètre (2D), du roulis d'azimut (2D) ou de la combinaison des deux (3D) ; les sondes de mesure restant fixes. Dans ce cas, l'étalement angulaire est commun à chaque arrivée principale.
- Par orientation mécanique de la sonde dans le plan d'élévation (2D), dans le plan d'azimut (2D) ou de la combinaison des deux (3D) ; l'objet sous test restant fixe. Dans ce cas, l'étalement angulaire peut être individualisé pour chaque arrivée principale.

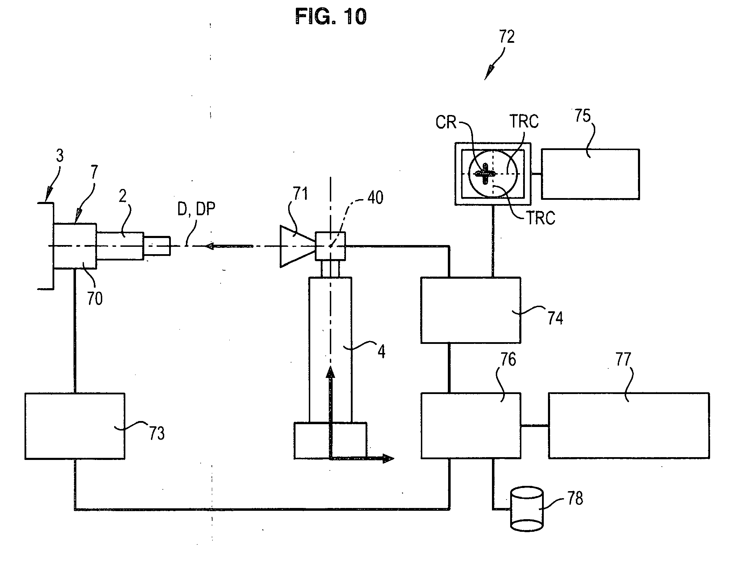

Suivant un mode de réalisation de l'invention représenté à la figure 10, il est prévu un système 7 de réglage individuel de l'alignement mécanique des sondes 2 par rapport au point cible 40. Ce système 7 de réglage d'alignement comporte, par exemple, une motorisation 70 de la sonde 2 sur sa structure 3 de support selon au moins un degré de liberté autre que suivant la direction DP de pointage de la sonde 2 vers le point cible 40 et par exemple selon au moins deux directions au niveau de chaque sonde 2, qui sont perpendiculaires ou sécantes par rapport à la direction DP de pointage de la sonde 2 vers le point cible 40. Il est prévu en outre par exemple un dispositif automatique 72 d'alignement, basé par exemple sur une caméra optique 71, par exemple du type CCD. Lors d'une phase d'installation du système de mesure ou encore d'une phase préparatoire à la mise en oeuvre d'une mesure de rayonnements électromagnétiques, la caméra optique 71 est par exemple positionnée précisément au point test 40 en étant fixée sur un mât 4 de référence et est orientée successivement vers chaque sonde 2 pour contrôler par l'image prise par la caméra 71 le bon positionnement et le bon alignement de la sonde 2, la sonde 2 formant une trace identifiable CR, par exemple en forme de croix, sur l'image prise par la caméra 71. A la figure 10, le système 7 comporte un bloc 70 de motorisation de la sonde 2 sur la structure 3 de support suivant les trois dimensions de l'espace pour pouvoir déplacer la sonde 2 suivant ces trois dimensions par rapport à la structure 3, en translation et/ou en rotation. Un contrôleur multiaxe 73 permet d'actionner le bloc 70 de motorisation suivant ses degrés de liberté. La caméra 71 est reliée à un module 74 d'analyse de l'image qu'elle fournit pour détecter dans cette image la trace CR de la sonde 2, l'image de la caméra 71 pouvant être par exemple en plus affichée sur un écran 75 de contrôle. Le module 74 d'analyse d'image est relié à un module 76 de gestion, lui-même commandant le contrôleur multiaxe 73 pour asservir en positions la trace laissée par la sonde 2 dans l'image de la caméra 71 sur une trace TRC de consigne prédéterminée, correspondant au bon alignement de la direction DP de pointage sur le point test 40, cette trace TRC étant une cible logicielle. Le module 76 est donc programmé pour déplacer par l'intermédiaire du contrôleur 73 et du bloc 70 de motorisation la sonde 2 par rapport à sa structure 3 de support, pour que la trace réelle CR de la sonde coïncide avec la trace TRC de consigne. Le module 76 est relié à une interface 77 de programmation par l'utilisateur et à une mémoire 78 de sauvegarde des traces et/ou réglages effectués pour chaque sonde 2. La sonde est ensuite maintenue par le bloc 70 de motorisation dans la position d'alignement sur le point cible 40.

On garantit ainsi que chaque sonde 2 est bien alignée sur un même point cible 40 pour les mesures ultérieures pouvant être effectuées par la sonde 2 et notamment par exemple pour la réalisation ultérieure des étalements angulaires autour de chaque direction principale d'arrivée D.

La caméra optique peut par exemple également être couplée à une visée laser des sondes.

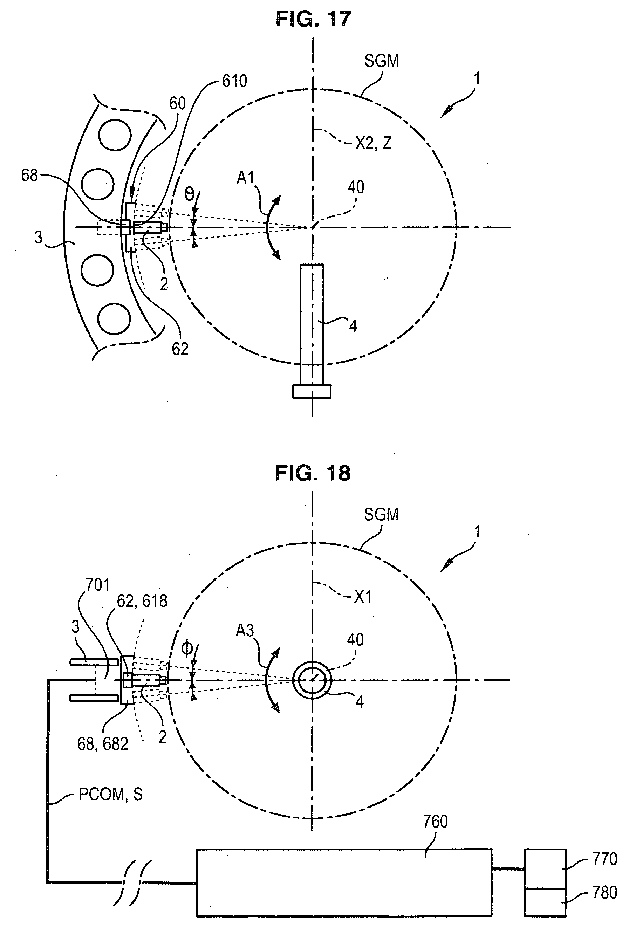

Suivant un mode de réalisation de l'invention représenté aux figures 17 et 18, le dispositif 6, 60 de déplacement mécanique pour réaliser l'étalement angulaire par rapport à la direction principale D de pointage est prévu entre la sonde 2 et la structure 3 de support de la sonde 2. Ce dispositif 6, 60 de déplacement mécanique permet de déplacer la sonde 2 par rapport à la structure 3 de support suivant au moins un degré de liberté, et par exemple selon au moins deux degrés de liberté, comme par exemple suivant au moins un déplacement angulaire autour d'un axe géométrique passant par le point cible 40, pouvant comprendre par exemple un déplacement angulaire A1 dans un premier plan non horizontal et par exemple vertical (en élévation θ à la figure 17), passant par le point cible 40 et/ou un autre déplacement angulaire A3 dans un autre plan horizontal (en azimut Φ à la figure 18), passant par le point cible 40 et sécant du premier plan.

Le dispositif 6 de déplacement mécanique est par exemple du type mécanisme goniométrique double autour de deux axes sécants X1, X2 et par exemple orthogonaux.

Dans le mode de réalisation représenté aux figures 17 et 18, le dispositif 6 de déplacement mécanique comporte un premier système 60 de déplacement angulaire relatif de la sonde 2 par rapport à la structure 3 de support suivant le premier angle A1. Ce premier système 60 de déplacement angulaire comporte par exemple un rail 62 pour guider suivant un arc de cercle centré sur le point cible 40 dans le premier plan un organe mené 610 supportant la sonde 2. L'organe 610 peut être déplacé angulairement suivant le premier angle A1 sur le rail 62, des moyens d'entraînement comprenant par exemple une motorisation étant prévus pour déplacer l'organe 610 sur le rail 62 de guidage.

Le dispositif 6 de déplacement mécanique comporte un deuxième système 68 de déplacement angulaire relatif de la sonde 2 par rapport à la structure 3 de support suivant le deuxième angle A3. Ce deuxième système 68 de déplacement angulaire comporte par exemple un rail 682 fixé pour guider suivant un arc de cercle centré sur le point cible 40 dans le deuxième plan un organe mené 618 supportant le rail 62. L'organe 618 peut être déplacé angulairement suivant le deuxième angle A3 sur le rail 682, des moyens d'entraînement comprenant par exemple une motorisation étant prévus pour déplacer l'organe 618 sur le rail 682 de guidage.

Le premier système 60 de déplacement angulaire relatif et le deuxième système 68 de déplacement angulaire relatif déplacent la sonde respectivement autour de deux axes géométriques sécants X1 et X2, passant par le point cible 40, qui sont par exemple orthogonaux et égaux respectivement et à l'axe horizontal et à l'axe vertical Z. Par conséquent, la sonde peut se déplacer sur une sphère géométrique SGM de mesure par rapport au point test 40 et à l'objet sous test qui s'y trouve.

Bien entendu, au lieu que ce soit aux figures 17 et 18, le rail 62 qui soit mobile suivant l'angle A3 sur le rail 682 fixé à la structure 3 de support, ce pourrait être le rail 682 qui est mobile suivant l'angle A1 sur le rail 62 fixé à la structure 3 de support.

La structure 3 de support peut être l'une des structures 3, 103, 203 décrite ci-dessus.

Aux figures 17 et 18, un actionneur 701 sur la structure 3 de support permet de générer les déplacements angulaires A1 et A3 du dispositif 6 sous la commande d'un module 760 de gestion, qui permet de contrôler l'actionneur 701 en θ et Φ.

Le module 760 est relié à une interface 770 de programmation par l'utilisateur et à une mémoire 780 d'enregistrement des positions PCOM de commande de la sonde 2.

On décrit ci-dessous un mode de fonctionnement valable pour les modes de réalisation décrits ci-dessus. Un calculateur, tel par exemple un ordinateur, qui est représenté par le module 760 de gestion, est prévu pour commander le ou les moteurs 620, 613, 64, 701 du ou des dispositifs 6, 60, 601, 63, 68 de déplacement mécanique pour déplacer la ou les sondes 2 suivant la statistique d'étalement angulaire. Cette statistique d'étalement angulaire est choisie à l'avance par l'utilisateur sur l'interface 770 du calculateur. Une fois que tous les paramètres de la statistique d'étalement angulaire ont été choisis, ces paramètres définissant de manière aléatoire l'étalement angulaire sont enregistrés dans la mémoire 780 du calculateur. Le calculateur calcule différentes positions angulaires pouvant être prises par la sonde par rapport à la direction principale D de pointage avec pour chaque position angulaire une probabilité calculée selon la statistique choisie. Le calculateur pioche alors parmi les positions angulaires enregistrées dans la mémoire, et ce d'une manière aléatoire respectant cette statistique d'étalement angulaire ayant été choisie, des positions successives PCOM de commande du ou des moteurs pour les instants se succédant. Les positions successives PCOM de commande sont enregistrées dans la mémoire avec leur instant d'apparition. Le au moins un moteur 620, 613, 64, 701 obéit alors aux positions PCOM de commande successives qu'il reçoit du calculateur 760 pour prendre aux instants successifs des positions réelles successives égales aux positions PCOM de commande successives, ces positions réelles correspondant donc chacune à un angle réel aléatoire de la au moins une sonde 2 par rapport à sa direction D de pointage, et ce par exemple en deux ou trois dimensions. A chaque position PCOM de commande d'un anglé réel de la au moins une sonde 2 par rapport à sa direction D de pointage est associé une amplitude (ou module) de commande et/ou une phase de commande de cette sonde 2, chaque sonde émettant un rayonnement électromagnétique dont l'amplitude et/ou la phase correspond à cette amplitude et/ou phase de commande. Cette amplitude et/ou phase de commande est appelée d'une manière générale signal S de commande de la au moins une sonde 2, qui est calculé par le calculateur pour la statistique d'étalement angulaire choisie. En effet, par exemple pour une statistique d'étalement angulaire du type gaussienne, l'amplitude du rayonnement de la sonde 2 décroît lorsque son angle réel d'écartement par rapport à sa direction D de pointage croît. Il est donc prévu de générer par le calculateur pour la au moins une sonde 2, en association avec le mouvement représentatif de la statistique d'étalement angulaire par rapport à la direction D de pointage, un signal S de commande variable de rayonnement émis par cette sonde 2, des moyens de calcul de ce signal S de commande en fonction de la statistique d'étalement angulaire étant prévus. Des moyens de mesure et d'acquisition radiofréquence sont prévus pour mesurer la réponse de l'objet sous test au rayonnement de la ou des sondes.

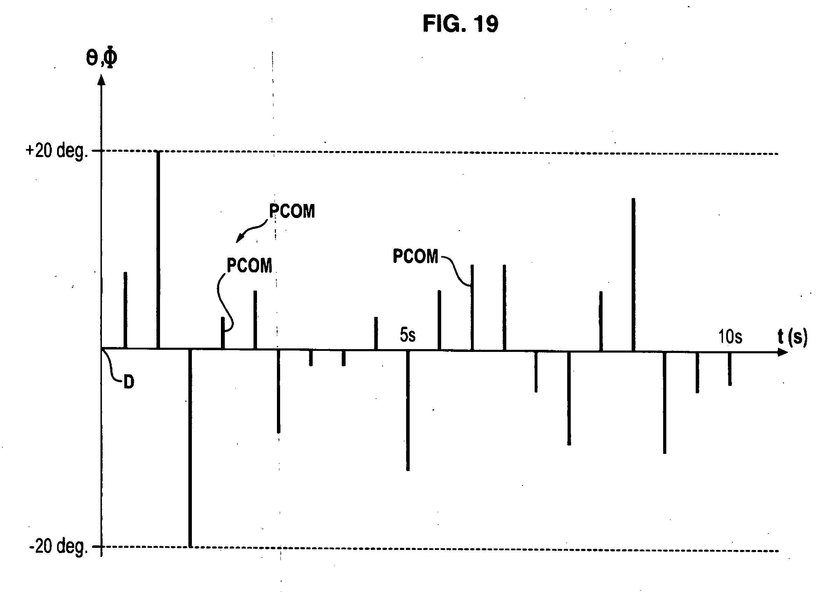

La figure 19 représente un exemple de déplacements angulaires contrôlés PCOM d'une sonde 2 suivant une statistique définie par le calculateur 760 en fonction du temps t en secondes (s). Cette statistique est mathématiquement déterminée par le calculateur. Ce déplacement angulaire peut être par exemple θ ou Φ, pouvant être égaux ou différents. Les déplacements angulaires PCOM sont pris autour de la direction principale D de pointage, formant l'origine de l'axe des ordonnées. Les déplacements angulaires contrôlés PCOM sont des angles réels pris successivement par la sonde 2 au cours du temps autour de la direction principale D de pointage. Les déplacements angulaires réels PCOM successifs sont imposés par des positions de commande successives PCOM imposées et déterminées par le calculateur 760. Par exemple, les déplacements angulaires PCOM représentés à la figure 19 ont une variation maximale de +/- 20° autour de la direction principale D de pointage. C'est un exemple numérique de l'angle réel PCOM de pointage de la sonde 2 en fonction du temps après un tirage statistique réalisé par le calculateur 760 pour une variation maximale de l'angle de +/- 20 degrés autour de la direction principale D. Il y a par exemple un même intervalle de temps régulier entre les déplacements angulaires réels PCOM successifs. Ainsi, le dispositif suivant l'invention permet de générer des scénarios électromagnétiques d'étalement angulaire représentant les conditions réelles du fonctionnement des appareils sous test. Les sondes 2 permettent d'envoyer ou de recevoir un rayonnement électromagnétique déterminé à l'avance vers ou depuis l'objet sous test placé au point cible 40 pour caractériser la réponse de l'objet au rayonnement électromagnétique émis. Bien entendu, il est possible d'envoyer des rayonnements électromagnétiques différents mais déterminés à l'avance suivant des lois calculées par un ordinateur pour simuler les environnements électromagnétiques en trois dimensions. Ainsi, les objets pouvant être testés au point cible 40 peuvent être des objets sous tests dits « passifs » comportant une ou plusieurs antennes alimentées par des câbles ou bien être des objets sous tests dits « actifs » ou encore « sans fil », c'est-à-dire des objets sous test ayant leur propre batterie d'alimentation, leur propre système de réception et/ou d'émission intégré et leur propre protocole de communication.

## Revendications

1. Procédé de test électromagnétique d'au moins un objet, procédé dans lequel on envoie par au moins une sonde (2) un rayonnement électromagnétique vers un point test (40) déterminé où se situe l'objet (OT) sous test,
**caractérisé en ce que**
l'on déplace d'une manière contrôlée la au moins une sonde (2) et un support (4) de l'objet (OT) sous test l'un par rapport à l'autre par un dispositif (6, 60, 63, 601, 68) de déplacement mécanique suivant une trajectoire qui est calculée à partir d'une statistique prédéterminée d'étalement angulaire de la direction du rayonnement par rapport à une direction principale (D) déterminée de pointage de la sonde (2) vers le point test (40), pour générer par la au moins une sonde (2) un rayonnement électromagnétique ayant cette statistique prédéterminée d'étalement angulaire par rapport à la direction principale (D) de pointage.

2. Procédé suivant la revendication 1, **caractérisé en ce que** ledit mouvement est situé dans un plan.

3. Procédé suivant la revendication 1, **caractérisé en ce que** ledit mouvement est situé dans un plan vertical pour générer la statistique prédéterminée d'étalement angulaire en élévation par le dispositif (6, 60, 63, 601, 68) de déplacement.

4. Procédé suivant la revendication 1, **caractérisé en ce que** ledit mouvement est situé dans un plan horizontal pour générer la statistique prédéterminée d'étalement angulaire en azimut par le dispositif (6, 60, 63, 601, 68) de déplacement.

5. Procédé suivant la revendication 1, **caractérisé en ce que** ledit mouvement est tridimensionnel pour générer la statistique prédéterminée d'étalement angulaire en élévation et en azimut par le dispositif (6, 60, 63, 601, 68) de déplacement.

6. Procédé suivant l'une quelconque des revendications 1 à 5, **caractérisé en ce qu'**en outre le dispositif (6) de déplacement mécanique est prévu entre ladite au moins une sonde (2) et une structure (3) de support de la au moins une sonde (2).

7. Procédé suivant la revendication 6, **caractérisé en ce que** le dispositif (6) de déplacement mécanique comprend au moins un dispositif (62, 68) de déplacement angulaire de la sonde (2) en rotation autour du point test (40) suivant au moins un degré de liberté par rapport à la structure (3) de support.

8. Procédé suivant l'une quelconque des revendications 1 à 7, **caractérisé en ce que** ladite au moins une sonde (2, 102, 202) est l'une ou plusieurs parmi un réseau d'une pluralité de sondes (2, 102, 202) supportées par une structure (3, 103, 203) de support, chaque sonde (2, 102, 202) ayant une direction principale (D) de pointage distincte vers le point test (40).

9. Procédé suivant la revendication 8, **caractérisé en ce que** l'objet (OT) sous test étant fixe sur le support (4), le dispositif (6, 60, 63, 601, 68) de déplacement mécanique fait subir un mouvement déterminé de la structure (3, 103, 203) de support des sondes (2, 102, 202) et du support (4) de l'objet (OT) sous test l'un par rapport à l'autre, pour faire subir à ladite au moins une sonde (2, 102, 202) le mouvement représentatif de la statistique prédéterminée d'étalement angulaire par rapport à sa direction principale (D) de pointage.

10. Procédé suivant la revendication 8, **caractérisé en ce que** l'objet (OT) sous test étant fixe sur le support (4), le dispositif (6, 60, 63, 601, 68) de déplacement mécanique fait subir un mouvement déterminé de la structure (3, 103, 203) de support des sondes (2, 102, 202) par rapport au support (4) fixe de l'objet (OT) sous test, pour faire subir à ladite au moins une sonde (2, 102, 202) le mouvement représentatif de la statistique prédéterminée d'étalement angulaire par rapport à sa direction principale (D) de pointage.

11. Procédé suivant la revendication 8, **caractérisé en ce que** l'objet (OT) sous test étant fixe sur le support (4), le dispositif (6, 60, 63, 601, 68) de déplacement mécanique fait subir un mouvement déterminé du support (4) de l'objet (OT) sous test par rapport à la structure fixe (3, 103, 203) de support des sondes (2, 102, 202), pour faire subir à ladite au moins une sonde (2, 102, 202) le mouvement représentatif de la statistique prédéterminée d'étalement angulaire par rapport à sa direction principale (D) de pointage.

12. Procédé suivant l'une quelconque des revendications 6 à 11, **caractérisé en ce que** la structure (103, 203) de support est en forme d'arche ou d'anneau sur laquelle ou lequel les sondes (2, 102, 202) sont supportées dans un plan.

13. Procédé suivant l'une quelconque des revendications 6 à 12, **caractérisé en ce que** la structure (3) de support est de forme tridimensionnelle sur laquelle les sondes (2) sont supportées d'une manière répartie en trois dimensions.

14. Procédé suivant l'une quelconque des revendications 6 à 13, **caractérisé en ce que** le dispositif (6, 60, 63, 601) de déplacement mécanique permet au moins un déplacement angulaire (A1) déterminé de glissement de la structure (3) de support et du support (4) de l'objet (OT) sous test l'un par rapport à l'autre au moins autour d'un axe géométrique non vertical.

15. Procédé suivant l'une quelconque des revendications 6 à 13, **caractérisé en ce que** le dispositif (6, 60, 63, 601) de déplacement mécanique permet un deuxième déplacement angulaire de rotation de la structure (3) de support et du support (4) de l'objet (OT) sous test l'un par rapport à l'autre au moins autour d'un axe géométrique vertical.

16. Procédé suivant la revendication 14 ou 15, **caractérisé en ce que** la structure (3) de support repose sur un socle inférieur (61), entre le socle (61) et la structure (3) de support est prévu un deuxième autre système (63) de déplacement angulaire permettant de déplacer la structure (3) de support par rapport au socle (61) d'un deuxième angle (A2) de même valeur absolue et opposé au déplacement angulaire (A1) de glissement du premier dispositif (60) de déplacement mécanique du support (4) par rapport à la structure (3) de support, afin que le support (4) de l'objet sous test conserve une position prescrite et sensiblement constante par rapport à la verticale, le dispositif (6) de déplacement mécanique du support (4) par rapport à la structure (3) de support étant appelé premier système (6) de déplacement relatif.

17. Procédé suivant la revendication précédente, **caractérisé en ce que** le deuxième autre système (63) de déplacement angulaire comporte une pluralité de rouleaux (631) de soutien d'une surface extérieure courbe (310) d'une paroi (31) de la structure (3) de support sur le socle (61) et au moins un moteur (64) d'entraînement d'au moins l'un des rouleaux (631) pour faire rouler dudit deuxième angle (A2) ladite surface extérieure courbe (310) de la paroi (31) de la structure (3) de support par rapport au socle (61).

18. Procédé suivant la revendication précédente, **caractérisé en ce qu'**il est prévu en outre :
un organe de commande du déplacement angulaire (A1) de glissement du premier système (6) de déplacement relatif,
au moins un capteur (66) de mesure d'un angle réel du support (4) de l'objet sous test par rapport à la verticale,
une boucle (65) d'asservissement du moteur (64) d'entraînement en fonction de l'angle mesuré par le capteur (66), pour que l'angle mesuré par le capteur (65) soit égal à une valeur constante correspondant à ladite position prescrite du support (4) par rapport à la verticale.

19. Procédé suivant l'une quelconque des revendications précédentes, **caractérisé en ce qu'**il est prévu une pluralité de sondes (2) réparties de manière équiangle suivant au moins une coordonnée sphérique autour d'un même point cible (40) des sondes (2).

20. Procédé suivant l'une quelconque des revendications précédentes, **caractérisé en ce qu'**il est prévu sur la au moins une sonde (2) un système (7) de réglage individuel de l'alignement mécanique de la sonde (2) par rapport à un point cible (40), point cible (40) où doit être centré l'objet sous test sur le support (4).

21. Procédé suivant la revendication précédente, **caractérisé en ce que** le système (7) de réglage individuel de l'alignement mécanique de la sonde (2) est associé à au moins une caméra optique (71) de détection positionnée au point cible (40) pour mesurer l'alignement mécanique de la sonde (2).

22. Procédé suivant l'une quelconque des revendications 20 et 21 **caractérisé en ce que** le système (7) de réglage individuel de l'alignement mécanique de la sonde (2) comporte une motorisation (70) de ladite sonde (2) sur la structure (3) de support, pour déplacer la sonde (2) par rapport à la structure (3) de support suivant au moins un degré de liberté autre que suivant une direction principale (DP) de pointage de la sonde (2) vers le point cible (40).

23. Procédé suivant les revendications 21 et 22, **caractérisé en ce qu'**il est prévu un module (74) d'analyse de l'image fournie par la caméra pour détecter dans cette image la trace (CR) de ladite sonde (2) et un module (76) d'asservissement de la motorisation (70) pour aligner la trace (CR) détectée de la sonde sur une trace (TRC) de consigne correspondant à l'alignement de la sonde (2) sur le point cible (40).

24. Procédé suivant l'une quelconque des revendications 1 à 23, **caractérisé en ce que** la statistique prédéterminée d'étalement angulaire est une loi double exponentielle.

25. Procédé suivant l'une quelconque des revendications 1 à 23, **caractérisé en ce que** la statistique prédéterminée d'étalement angulaire est une gaussienne centrée par rapport à la direction principale (D) de pointage et ayant un étalement angulaire défini par l'ouverture angulaire centrée autour de la direction principale (D) de pointage, pour laquelle la moitié de l'énergie maximale du rayonnement est transportée.

26. Procédé suivant l'une quelconque des revendications précédentes, **caractérisé en ce qu'**au moins un calculateur (760) comporte une interface (770) permettant à un utilisateur de choisir ladite statistique d'étalement angulaire,
le calculateur (760) calcule une pluralité de positions angulaires successives (PCOM) de commande du dispositif (6, 60, 601, 63, 68) de déplacement mécanique par rapport à la direction principale (D) prédéterminée de pointage, qui apparaissent suivant ladite statistique d'étalement angulaire ayant été choisie,
le calculateur envoie les positions angulaires successives de commande ayant été calculées à au moins un moteur (620, 613, 64, 701) du dispositif (6, 60, 601, 63, 68) de déplacement mécanique pour faire prendre à ladite au moins une sonde (2, 102, 202) des positions réelles successives déterminées correspondant aux positions (PCOM) de commande successives.

27. Procédé suivant la revendication précédente, **caractérisé en ce que** le calculateur calcule pour chaque position angulaire (PCOM) de commande un signal (S) de commande de l'intensité et/ou de la phase du rayonnement électromagnétique émis par ladite au moins une sonde (2, 102, 202).

28. Dispositif de test électromagnétique d'au moins un objet (OT) pour la mise oeuvre du procédé de test suivant l'une quelconque des revendications précédentes, le dispositif comportant au moins une sonde (2, 102, 202) d'émission d'un rayonnement électromagnétique vers un point test déterminé (40) où se situe l'objet (OT) sous test, ainsi qu'un support (4) pour l'objet sous test,
**caractérisé en ce que**
le dispositif de test comporte en outre un dispositif (6, 60, 63, 601, 68) de déplacement mécanique d'une manière contrôlée de la au moins une sonde (2, 102, 202) et du support (4) de l'objet sous test l'un par rapport à l'autre suivant une trajectoire qui est calculée à partir d'une statistique prédéterminée d'étalement angulaire de la direction du rayonnement par rapport à une direction principale (D) déterminée de pointage de la sonde (2) vers le point test (40) pour générer par la au moins une sonde un rayonnement électromagnétique ayant cette statistique prédéterminée d'étalement angulaire par rapport à la direction principale (D) de pointage.

## Patentansprüche

1. Elektromagnetisches Testverfahren mindestens eines Objekts, wobei bei dem Verfahren von mindestens einer Sonde (2) eine elektromagnetische Strahlung an einen bestimmten Testpunkt (40) geschickt wird, wo sich das Testobjekt (OT) befindet,
**dadurch gekennzeichnet, dass**
die mindestens eine Sonde (2) und ein Halter (4) des Testobjekts (OT) in Bezug zueinander von einer mechanischen Verlagerungsvorrichtung (6, 60, 63, 601, 68) gemäß einer Bewegungsbahn kontrolliert verlagert werden, die mittels einer vorbestimmten Winkelstreuungsstatistik der Richtung der Strahlung in Bezug auf eine vorbestimmte Hauptzielrichtung (D) der Sonde (2) auf den Testpunkt (40) berechnet wird, um mit der mindestens einen Sonde (2) eine elektromagnetische Strahlung zu erzeugen, die diese vorbestimmte Winkelstreuungsstatistik in Bezug auf die Hauptzielrichtung (D) hat.

2. Verfahren nach Anspruch 1, **dadurch gekennzeichnet, dass** die Bewegung in einer Ebene erfolgt.

3. Verfahren nach Anspruch 1, **dadurch gekennzeichnet, dass** die Bewegung in einer vertikalen Ebene erfolgt, um die vorbestimmte Elevations-Winkelstreuungsstatistik mit der Verlagerungsvorrichtung (6, 60, 63, 601, 68) zu erzeugen.

4. Verfahren nach Anspruch 1, **dadurch gekennzeichnet, dass** die Bewegung in einer horizontalen Ebene erfolgt, um die vorbestimmte Azimut-Winkelstreuungsstatistik mit der Verlagerungsvorrichtung (6, 60, 63, 601, 68) zu erzeugen.

5. Verfahren nach Anspruch 1, **dadurch gekennzeichnet, dass** die Bewegung dreidimensional ist, um die vorbestimmte Elevations- und Azimut-Winkelstreuungsstatistik mit der Verlagerungsvorrichtung (6, 60, 63, 601, 68) zu erzeugen.

6. Verfahren nach einem der Ansprüche 1 bis 5, **dadurch gekennzeichnet, dass** die mechanische Verlagerungsvorrichtung (6) ferner zwischen der mindestens einen Sonde (2) und einer Halterstruktur (3) der mindestens einen Sonde (2) vorgesehen ist.

7. Verfahren nach Anspruch 6, **dadurch gekennzeichnet, dass** die mechanische Verlagerungsvorrichtung (6) mindestens eine Winkelverlagerungsvorrichtung (62, 68) der Sonde (2) in Rotation um den Testpunkt (40) gemäß mindestens einem Freiheitsgrad in Bezug auf die Halterstruktur (3) umfasst.

8. Verfahren nach einem der Ansprüche 1 bis 7, **dadurch gekennzeichnet, dass** die mindestens eine Sonde (2, 102, 202) eine oder mehrere eines Netzwerks einer Vielzahl von Sonden (2, 102, 202) ist, die von einer Halterstruktur (3, 103, 203) gehalten werden, wobei jede Sonde (2, 102, 202) eine verschiedene Hauptzielrichtung (D) auf den Testpunkt (40) hat.

9. Verfahren nach Anspruch 8, **dadurch gekennzeichnet, dass**, wobei das Testobjekt (OT) auf dem Halter (4) befestigt ist, die mechanische Verlagerungsvorrichtung (6, 60, 63, 601, 68) eine bestimmte Bewegung der Halterstruktur (3, 103, 203) der Sonden (2, 102, 202) und des Halters (4) des Testobjekts (OT) in Bezug zueinander veranlasst, damit die mindestens eine Sonde (2, 102, 202) die repräsentative Bewegung der vorbestimmten Winkelstreuungsstatistik in Bezug auf ihre Hauptzielrichtung (D) durchführt.

10. Verfahren nach Anspruch 8, **dadurch gekennzeichnet, dass**, wobei das Testobjekt (OT) auf dem Halter (4) befestigt ist, die mechanische Verlagerungsvorrichtung (6, 60, 63, 601, 68) eine bestimmte Bewegung der Halterstruktur (3, 103, 203) der Sonden (2, 102, 202) in Bezug auf den festen Halter (4) des Testobjekts (OT) veranlasst, damit die mindestens eine Sonde (2, 102, 202) die repräsentative Bewegung der vorbestimmten Winkelstreuungsstatistik in Bezug auf ihre Hauptzielrichtung (D) durchführt.

11. Verfahren nach Anspruch 8, **dadurch gekennzeichnet, dass**, wobei das Testobjekt (OT) auf dem Halter (4) befestigt ist, die mechanische Verlagerungsvorrichtung (6, 60, 63, 601, 68) eine bestimmte Bewegung des Halters (4) des Testobjekts (OT) in Bezug auf die feste Halterstruktur (3, 103, 203) der Sonden (2, 102, 202) veranlasst, damit die mindestens eine Sonde (2, 102, 202) die repräsentative Bewegung der vorbestimmten Winkelstreuungsstatistik in Bezug auf ihre Hauptzielrichtung (D) durchführt.

12. Verfahren nach einem der Ansprüche 6 bis 11, **dadurch gekennzeichnet, dass** die Halterstruktur (103, 203) eine Bogen- oder Ringform hat, auf welcher die Sonden (2, 102, 202) in einer Ebene gehalten werden.

13. Verfahren nach einem der Ansprüche 6 bis 12, **dadurch gekennzeichnet, dass** die Halterstruktur (3) eine dreidimensionale Struktur hat, auf welcher die Sonden (2) in drei Dimensionen verteilt gehalten werden.

14. Verfahren nach einem der Ansprüche 6 bis 13, **dadurch gekennzeichnet, dass** die mechanische Verlagerungsvorrichtung (6, 60, 63, 601) mindestens eine bestimmte gleitende Winkelverlagerung (A1) der Halterstruktur (3) und des Halters (4) des Testobjekts (OT) in Bezug zueinander mindestens um eine nicht vertikale geometrische Achse erlaubt.

15. Verfahren nach einem der Ansprüche 6 bis 13, **dadurch gekennzeichnet, dass** die mechanische Verlagerungsvorrichtung (6, 60, 63, 601) eine zweite Rotations-Winkelverlagerung der Halterstruktur (3) und des Halters (4) des Testobjekts (OT) in Bezug zueinander mindestens um eine vertikale geometrische Achse erlaubt.

16. Verfahren nach Anspruch 14 oder 15, **dadurch gekennzeichnet, dass** die Halterstruktur (3) auf einem unteren Sockel (61) ruht, zwischen dem Sockel (61) und der Halterstruktur (3) ein zweites anderes Winkelverlagerungssystem (63) vorgesehen ist, das erlaubt, die Halterstruktur (3) in Bezug zum Sockel (61) in einem zweiten Winkel (A2) mit demselben absoluten Wert und entgegengesetzt zur gleitenden Winkelverlagerung (A1) der ersten mechanischen Verlagerungsvorrichtung (60) des Halters (4) in Bezug auf die Halterstruktur (3) zu verlagern, damit der Halter (4) des Testobjekts eine vorgeschriebene und etwa konstante Position in Bezug auf die Vertikale beibehält, wobei die mechanische Verlagerungsvorrichtung (6) des Halters (4) in Bezug auf die Halterstruktur (3) als erstes System (6) relativer Verlagerung bezeichnet wird.

17. Verfahren nach vorangehendem Anspruch, **dadurch gekennzeichnet, dass** das zweite andere Winkelverlagerungssystem (63) eine Vielzahl von Rollen (631) zur Stützung einer gekrümmten Außenfläche (310) einer Wand (31) der Halterstruktur (3) auf dem Sockel (61) und mindestens einen Antriebsmotor (64) zum Antrieb mindestens einer der Rollen (631) aufweist, um die gekrümmte Außenfläche (310) der Wand (31) der Halterstruktur (3) in Bezug auf den Sockel (61) vom zweiten Winkel (A2) zu rollen.

18. Verfahren nach vorangehendem Anspruch, **dadurch gekennzeichnet, dass** ferner vorgesehen ist:
ein Organ zur Steuerung der gleitenden Winkelverlagerung (A1) des ersten Systems (6) relativer Verlagerung,
mindestens ein Fühler (66) zur Mesung eines realen Winkels des Halters (4) des Testobjekts in Bezug auf die Vertikale,
einen Regelkreis (65) zur Regelung des Antriebsmotors (64) in Abhängigkeit von dem vom Fühler (66) gemessenen Winkel, damit der vom Fühler (65) gemessene Winkel gleich einem konstanten Wert ist, welcher der vorgeschriebenen Position des Halters (4) in Bezug auf die Vertikale entspricht.

19. Verfahren nach einem der vorangehenden Ansprüche, **dadurch gekennzeichnet, dass** eine Vielzahl von Sonden (2) vorgesehen ist, die in gleichem Winkel gemäß mindestens einer Raumkoordinate um einen selben Zielpunkt (40) der Sonden (2) verteilt sind.

20. Verfahren nach einem der vorangehenden Ansprüche, **dadurch gekennzeichnet, dass** auf der mindestens einen Sonde (2) ein individuelles Einstellsystem (7) zur Einstellung der mechanischen Ausrichtung der Sonde (2) in Bezug auf einen Zielpunkt (40) vorgesehen ist, den Zielpunkt (40), auf dem das Testobjekt auf dem Halter (4) zentriert sein muss.

21. Verfahren nach vorangehendem Anspruch, **dadurch gekennzeichnet, dass** das individuelle Einstellsystem (7) zur Einstellung der mechanischen Ausrichtung der Sonde (2) mindestens einer optischen Detektionskamera (71) zugeordnet ist, die am Zielpunkt (40) positioniert ist, um die mechanische Ausrichtung der Sonde (2) zu messen.

22. Verfahren nach einem der Ansprüche 20 und 21, **dadurch gekennzeichnet, dass** das individuelle Einstellsystem (7) zur Einstellung der mechanischen Ausrichtung der Sonde (2) eine Motorisierung (70) der Sonde (2) auf der Halterstruktur (3) aufweist, um die Sonde (2) in Bezug auf die Halterstruktur (3) gemäß mindestens einem anderen Freiheitsgrad als gemäß einer Hauptzielrichtung (DP) der Sonde (2) zum Zielpunkt (40) zu verlagern.

23. Verfahren nach den Ansprüchen 21 und 22, **dadurch gekennzeichnet, dass** ein Analysemodul (74) des von der Kamera gelieferten Bilds vorgesehen ist, um auf diesem Bild die Spur (CR) der Sonde (2) zu ermitteln, und ein Regelungsmodul (76) zur Regelung der Motorisierung (70), um die von der Sonde ermittelte Spur (CR) auf eine Referenzspur (TRC) auszurichten, welche der Ausrichtung der Sonde (2) auf den Zielpunkt (40) entspricht.

24. Verfahren nach einem der Ansprüche 1 bis 23, **dadurch gekennzeichnet, dass** die vorbestimmte Winkelstreuungsstatistik ein doppelt exponentielles Gesetz ist.

25. Verfahren nach einem der Ansprüche 1 bis 23, **dadurch gekennzeichnet, dass** die vorbestimmte Winkelstreuungsstatistik eine in Bezug auf die Hauptzielrichtung (D) zentrierte Gauß' sche ist und eine Winkelstreuung hat, die von der Winkelöffnung, zentriert um die Hauptzielrichtung (D), definiert ist, für welche die Hälfte der maximalen Energie der Strahlung transportiert wird.

26. Verfahren nach einem der vorangehenden Ansprüche, **dadurch gekennzeichnet, dass** mindestens ein Rechner (760) eine Schnittstelle (770) aufweist, die es einem Benutzer erlaubt, die Winkelstreuungsstatistik auszuwählen,
wobei der Rechner (760) ein Vielzahl aufeinanderfolgender Winkelsteuerpositionen (PCOM) zur Steuerung der mechanischen Verlagerungsvorrichtung (6, 60, 601, 63, 68) in Bezug auf die vorbestimmte Hauptzielrichtung (D) berechnet, die gemäß der gewählten Winkelstreuungsstatistik erscheinen,
wobei der Rechner die berechneten aufeinanderfolgenden Winkelsteuerpositionen an mindestens einen Motor (620, 613, 64, 701) der mechanischen Verlagerungsvorrichtung (6, 60, 601, 63, 68) schickt, damit die mindestens eine Sonde (2, 102, 202) aufeinanderfolgende reale Positionen einnimmt, die den aufeinanderfolgenden Winkelsteuerpositionen (PCOM) entsprechen.

27. Verfahren nach vorangehendem Anspruch, **dadurch gekennzeichnet, dass** der Rechner für jede Winkelsteuerposition (PCOM) ein Steuersignal (S) zur Steuerung der Intensität und/oder der Phase der von der mindestens einen Sonde (2, 102, 202) gesendeten elektromagnetischen Strahlung berechnet.

28. Elektromagnetische Testvorrichtung mindestens eines Objekts (OT) für die Umsetzung des Testverfahrens nach einem der vorangehenden Ansprüche, wobei die Vorrichtung mindestens eine Sonde (2, 102, 202) zur Sendung einer elektromagnetischen Strahlung an einen bestimmten Testpunkt (40) aufweist, wo sich das Testobjekt (OT) befindet, sowie einen Halter (4) für das Testobjekt,
**dadurch gekennzeichnet, dass**
die Testvorrichtung ferner eine mechanische Vorrichtung (6, 60, 63, 601, 68) für die gesteuerte Verlagerung der mindestens einen Sonde (2, 102, 202) und des Halters (4) des Testobjekts in Bezug zueinander gemäß einer Bewegungsbahn aufweist, die mittels einer vorbestimmten Winkelstreuungsstatistik der Richtung der Strahlung in Bezug auf eine vorbestimmte Hauptzielrichtung (D) der Sonde (2) auf den Testpunkt (40) berechnet wird, um mit der mindestens einen Sonde eine elektromagnetische Strahlung zu erzeugen, die diese vorbestimmte Winkelstreuungsstatistik in Bezug auf die Hauptzielrichtung (D) hat.

## Claims

1. A method for electromagnetic testing of at least one object, a method in which electromagnetic radiation is sent by at least one probe (2) towards a determined test point (40) where the object (OT) being tested is located,
**characterised in that**
the at least one probe (2) and a support (4) for the object (OT) being tested are moved in a controlled manner relative to each other by a mechanical displacement device (6, 60, 63, 601, 68) according to a trajectory which is calculated from a predetermined angular spread statistic of the direction of the radiation relative to a determined principal aiming direction (D) of the probe (2) towards the test point (40) to generate electromagnetic radiation having this predetermined angular spread statistic relative to the principal aiming direction (D) by the at least one probe (2).

2. The method according to Claim 1, **characterised in that** said movement is located in a plane.

3. The method according to Claim 1, **characterised in that** said movement is located in a vertical plane to generate the predetermined angular spread statistic in elevation by the displacement device (6, 60, 63, 601, 68).

4. The method according to Claim 1, **characterised in that** said movement is located in a horizontal plane to generate the predetermined angular spread statistic in azimuth by the displacement device (6, 60, 63, 601, 68).

5. The method according to Claim 1, **characterised in that** said movement is three-dimensional to generate the predetermined angular spread statistic in elevation and in azimuth by the displacement device (6, 60, 63, 601, 68).

6. The method according to any one of Claims 1 to 5, **characterised in that** the mechanical displacement device (6) is also provided between said at least one probe (2) and a support structure (3) for supporting of the at least one probe (2).

7. The method according to Claim 6, **characterised in that** the mechanical displacement device (6) comprises at least one angular displacement device (62, 68) of the probe (2) in rotation around the test point (40) according to at least one degree of liberty relative to the support structure (3).

8. The method according to any one of Claims 1 to 7, **characterised in that** said at least one probe (2, 102, 202) is one or more in a network of a plurality of probes (2, 102, 202) supported by a support structure (3, 103, 203), each probe (2, 102, 202) having a separate principal aiming direction (D) towards the test point (40).

9. The method according to Claim 8, **characterised in that** the object (OT) being tested being fixed on the support (4), the mechanical displacement device (6, 60, 63, 601, 68) makes a determined movement of the support structure (3, 103, 203) for supporting the probes (2, 102, 202) and of the support (4) for the object (OT) being tested relative to each other to have said at least one probe (2, 102, 202) undergo the movement representative of the predetermined angular spread statistic relative to its principal aiming direction (D).

10. The method according to Claim 8, **characterised in that** the object (OT) being tested being fixed on the support (4), the mechanical displacement device (6, 60, 63, 601, 68) makes a determined movement of the support structure (3, 103, 203) for supporting the probes (2, 102, 202) relative to the fixed support (4) of the object (OT) being tested, to have said at least one probe (2, 102, 202) undergo the movement representative of the predetermined angular spread statistic relative to its principal aiming direction (D).

11. The method according to Claim 8, **characterised in that** the object (OT) being tested being fixed on the support (4), the mechanical displacement device (6, 60, 63, 601, 68) makes a determined movement of the support (4) for the object (OT) being tested relative to the fixed support structure (3, 103, 203) for supporting of the probes (2, 102, 202) to have said at least one probe (2, 102, 202) undergo the movement representative of the predetermined angular spread statistic relative to its principal aiming direction (D).

12. The method according to any one of Claims 6 to 11, **characterised in that** the support structure (103, 203) is in the form of an arch or ring on which the probes (2, 102, 202) are supported in a plane.

13. The method according to any one of Claims 6 to 12, **characterised in that** the support structure (3) is three-dimensional in form on which the probes (2) are supported distributed in three dimensions.

14. The method according to any one of Claims 6 to 13, **characterised in that** the mechanical displacement device (6, 60, 63, 601) allows at least one determined angular sliding displacement (A1) of the support structure (3) and of the support (4) for the object (OT) being tested relative to each other at least about a non-vertical geometric axis.

15. The method according to any one of Claims 6 to 13, **characterised in that** the mechanical displacement device (6, 60, 63, 601) allows a second angular rotation displacement of the support structure (3) and of the support (4) for the object (OT) being tested relative to each other at least about a vertical geometric axis.

16. The method according to Claim 14 or 15, **characterised in that** the support structure (3) rests on a lower base (61), provided between the base (61) and the support structure (3) is a second other angular displacement system (63) for moving the support structure (3) relative to the base (61) by a second angle (A2) of the same absolute value and opposite the angular sliding displacement (A1) of the first mechanical displacement device (60) of the support (4) relative to the support structure (3), so that the support (4) of the object being tested retains a prescribed and substantially constant position relative to the vertical, the mechanical displacement device (6) for the support (4) relative to the support structure (3) being called a first system (6) of relative displacement.

17. The method according to the preceding claim, **characterised in that** the second other angular displacement system (63) comprises a plurality of support rollers (631) for supporting of an outer curved surface (310) of a wall (31) of the support structure (3) on the base (61) and at least one drive motor (64) for driving at least one of the rollers (631) to make said outer curved surface (310) of the wall (31) of the support structure (3) roll relative to the base (61) by said second angle (A2).

18. The method according to the preceding claim, **characterised in that** there is also provided:
a control element for controlling of the angular sliding displacement (A1) of the first system (6) of relative displacement,
at least one measuring sensor (66) for measuring of a real angle of the support (4) for the object being tested relative to the vertical,
a feedback loop (65) for controlling of the drive motor (64) as a function of the angle measured by the sensor (66) so that the angle measured by the sensor (65) is equal to a constant value corresponding to said prescribed position of the support (4) relative to the vertical.

19. The method according to any one of the preceding claims, **characterised in that** a plurality of probes (2) is provided distributed equiangularly according to at least one spherical coordinate about a same target point (40) of the probes (2).

20. The method according to any one of the preceding claims, **characterised in that** provided on the at least one probe (2) is an individual regulation system (7) for regulating of the mechanical alignment of the probe (2) relative to a target point (40), a target point (40) where the object being tested on the support (4) must be centred.

21. The method according to the preceding claim, **characterised in that** the individual regulation system (7) for regulating of the mechanical alignment of the probe (2) is associated to at least one optical detection camera (71) positioned at the target point (40) for measuring the mechanical alignment of the probe (2).

22. The method according to any one of Claims 20 and 21 **characterised in that** the individual regulation system (7) for regulating of the mechanical alignment of the probe (2) comprises motorisation (70) of said probe (2) on the support structure (3) for shifting the probe (2) relative to the support structure (3) according to at least one degree of liberty other than according to a principal aiming direction (DP) of the probe (2) towards the target point (40).

23. The method according to Claims 21 and 22, **characterised in that** an analysis module (74) of the image supplied by the camera is provided to detect in this image the trace (CR) of said probe (2) and a feedback module for controlling (76) of the motorisation (70) to align the detected trace (CR) of the probe on a setpoint trace (TRC) corresponding to the alignment of the probe (2) on the target point (40) is provided.

24. The method according to any one of Claims 1 to 23, **characterised in that** the predetermined angular spread statistic is a double exponential law.

25. The method according to any one of Claims 1 to 23, **characterised in that** the predetermined angular spread statistic is a Gaussian centred relative to the principal aiming direction (D) and having an angular spread defined by the angular opening centred around the principal aiming direction (D), for which the half of the maximal energy of the radiation is transported.

26. The method according to any one of the preceding claims, **characterised in that** at least one computer (760) comprises an interface (770) allowing a user to select said angular spread statistic,
the computer (760) calculates a plurality of successive angular control positions (PCOM) for controlling of the mechanical displacement device (6, 60, 601, 63, 68) relative to the predetermined principal aiming direction (D), which appear according to said angular spread statistic having been selected,
the computer sends the successive angular control positions having been calculated to at least one motor (620, 613, 64, 701) of the mechanical displacement device (6, 60, 601, 63, 68) so that said at least one probe (2, 102, 202) takes determined real successive positions corresponding to the successive control positions (PCOM).

27. The method according to the preceding claim, **characterised in that** the computer calculates for each angular control position (PCOM) a control signal (S) for controlling of the intensity and/or of the phase of the electromagnetic radiation emitted by said at least one probe (2, 102, 202).

28. A device for electromagnetic testing of at least one object (OT) for executing the test method according to any one of the preceding claims, the device comprising at least one probe (2, 102, 202) for emission of electromagnetic radiation towards a determined test point (40) where the object (OT) being tested is located, as well as a support (4) for the object being tested,
**characterised in that**
the test device further comprises a mechanical displacement device (6, 60, 63, 601, 68) for mechanically displacing of the at least one probe (2, 102, 202) and of the support (4) for the object being tested relative to each other in a controlled manner according to a trajectory which is calculated from a predetermined angular spread statistic of the direction of the electromagnetic radiation relative to a determined principal aiming direction (D) of the probe (2) towards the test point (40) to generate electromagnetic radiation having this predetermined angular spread statistic relative to the principal aiming direction (D) by the at least one probe.
